# EUROPÄISCHE PATENTSCHRIFT

(11) **EP 2 596 404 B1**
(45) Veröffentlichungstag und Bekanntmachung des Hinweises auf die Patenterteilung: **09.07.2014**
(21) Anmeldenummer: 11749752.9
(22) Anmeldetag: 12.07.2011
(51) Int. Cl.: G03F 7/20, G03F 7/38

(54) **UV-LED-BESTRAHLUNG UMFASSENDES VERFAHREN ZUR HERSTELLUNG VON FLEXODRUCKFORMEN**
PROCESS FOR THE FABRICATION OF FLEXOGRAPHIC PRINTING PLATES COMPRISING UV LED IRRADIATION
PROCÉDÉ POUR LA FABRICATION DES PLAQUES D'IMPRESSION FLEXOGRAPHIQUES COMPRENANT L'IRRADIATION AU MOYEN DE LED UV

(30) Priorität: 19.07.2010 DE 102010031527
(43) Veröffentlichungstag der Anmeldung: 29.05.2013
(73) Patentinhaber: Flint Group Germany GmbH, 70469 Stuttgart (DE)
(72) Erfinder: SCHADEBRODT, Jens, 55129 Mainz (DE); BECKER, Armin, 67259 Großniedesheim (DE); STEBANI, Uwe, 67592 Flörsheim-Dalsheim (DE); THATE, Maximilian, 67098 Bad Dürkheim (DE)
(74) Vertreter: Schuck, Alexander
(86) Internationale Anmeldenummer: PCT/EP2011/061829
(87) Internationale Veröffentlichungsnummer: WO 2012/010459

(56) Entgegenhaltungen:
- EP-A1- 0 741 330
- EP-A1- 2 275 870
- WO-A1-96/16356
- WO-A2-2008/135865
- US-A1- 2005 130 075
- US-A1- 2010 143 840

## Beschreibung

Die Erfindung betrifft ein Verfahren zur Herstellung von Flexodruckformen sowie eine dazu geeignete Vorrichtung.

Das am weitesten verbreitete Verfahren zur Herstellung von Flexodruckformen umfasst die bildmäßige Belichtung der fotopolymerisierbaren reliefbildenden Schicht mit aktinischer Strahlung, vor allem langwelliger UV-Strahlung, durch eine fotografisch oder digital erstellte Maske. In einem weiteren Verfahrensschritt wird die belichtete Schicht mit einem geeigneten Lösemittel bzw. Lösemittelgemisch behandelt, wobei die unbelichteten, nicht polymerisierten Bereiche der reliefbildenden Schicht gelöst werden, während die belichteten, polymerisierten Bereiche erhalten bleiben und das Relief der Druckplatte bilden.

Digitale Bebilderung von fotoempfindlichen Flexodruckelementen ist prinzipiell bekannt. Hierbei werden Flexodruckelemente nicht auf klassische Art und Weise durch Auflegen einer fotografischen Maske, gefolgt vom Belichten durch die fotografische Maske hindurch erzeugt. Die Maske wird vielmehr mittels geeigneter Techniken in-situ direkt auf dem Flexodruckelement erzeugt. Flexodruckelemente können beispielsweise mit opaken, IRablativen Schichten (EP-B 654 150, EP-A 1 069 475) versehen werden, die mittels IR-Lasern bildmäßig ablatierbar sind. Weitere bekannte Techniken umfassen mittels Ink-Jet-Technik beschreibbare Schichten (EP-A 1 072 953) oder thermografisch beschreibbare Schichten (EP-A 1 070 989). Nach dem bildmäßigen Beschreiben dieser Schichten mittels der dazu geeigneten Techniken wird die fotopolymerisierbare Schicht durch die gebildete Maske hindurch mittels aktinischem Licht belichtet.

Die bildmäßige Belichtung mit aktinischer Strahlung erfolgt standardmäßig unter Verwendung von UV-Strahlungsquellen, die im Bereich von ca. 315 nm bis 420 nm (langwelliger UV-Bereich bis Violettbereich des sichtbaren Spektrums) eine signifikante Emission besitzen. Am häufigsten werden als Strahlungsquelle UV/A-Röhren verwendet, welche ein Emissionsmaximum bei einer Wellenlänge von ca. 370 nm besitzen und UV-Intensitäten von 10 mW/cm² - 30 mW/cm², gemessen in einem Abstand von 50 mm (typischer Abstand der Strahlungsquelle von der Oberfläche des Flexodruckelements) erzeugen. Solche UV/A-Röhren sind beispielsweise unter der Bezeichnung "R-UVA TL 10R" von Philips erhältlich.

Weiterhin werden auch Quecksilberdampflampen für die bildmäßige Belichtung verwendet, wobei dotierte Quecksilbermitteldruckdampflampen bevorzugt werden, da z.B. mittels Eisen- und/oder Galliumdotierung der im UV/A-Bereich emittierte Anteil erhöht werden kann. Einheiten, welche mindestens eine Quecksilberdampflampe sowie einen Reflektor umfassen, werden im Folgenden als UV-Strahler bezeichnet. Das Emissionsspektrum von UV-Strahlern beinhaltet neben den besagten Anteilen von UV/A-Strahlung auch Anteile von UV/B- und UV/C-Strahlung. Bei der bildmäßigen Belichtung können diese kürzenivelligen UV-Strahlungsanteile zu unerwünschten Nebeneffekten führen, beispielsweise zu einer Versprödung der bestrahlten Oberfläche oder zur Bildung von Ozon. Daher werden für die bildmäßige Belichtung meist Quecksilbermitteldruckdampflampen ausgewählt, bei denen durch eine geeignete Auswahl des Lampenglases die Emission von UV/B- und UV/C-Strahlung stark reduziert wird. Außerdem kommen auch Filter zum Einsatz, welche die UV/B- und UV/C-Strahlungsanteile im wesentlichen absorbieren, für UV/A-Strahlung hingegen im wesentlichen durchlässig sind. Da die meisten erhältlichen UV-Strahler etwa 40 % der aufgenommenen elektrischen Leistung in Wärmestrahlung umwandeln, kann die eigentlich hohe Intensität der UV-Strahler nicht ohne weiteres direkt auf das Substrat übertragen werden, da eine zu hohe Temperaturbelastung das Flexodruckelement schädigen kann. Um die Wärmebelastung des zu bestrahlenden Substrats zu reduzieren, muss der Abstand des UV-Strahlers zum Substrat relativ groß, beispielsweise 500 mm, gewählt werden, wodurch die auf das Substrat auftreffende UV-Intensität reduziert ist. Mit speziellen Reflektoren und/oder Spiegeln, die für Infrarotstrahlung mindestens teilweise durchlässig sind, UV-Strahlung hingegen im Wesentlichen reflektieren, kann ebenfalls die Temperaturbelastung des zu bestrahlenden Substrats reduziert werden. Dennoch ist es meist nicht möglich, UV/A-Intensitäten von >100 mW/cm² auf Höhe des Flexodruckelements zu realisieren, da dieses aufgrund der starken Erwärmung ansonsten geschädigt wird und bei Flexodruckelementen mit PET-Folienträger zusätzlich die Gefahr des Dimensionsstabilitätsverlusts besteht.

Allerdings werden zur Strahlungshärtung von fotopolymerisierbaren Zusammensetzungen zunehmend auch UV-Licht emittierende LEDs (Light Emitting Diodes) eingesetzt.

Gängige LED-Systeme für die UV-Härtung konzentrieren sich in der Praxis gegenwärtig auf die Wellenlängen 395 nm sowie 365 nm. Weitere mögliche Spektralbereiche sind 350 nm, 375 nm, 385 nm, 405 nm. In wissenschaftlichen Veröffentlichungen werden außerdem noch die Wellenlängen 210, 250 nm, 275 nm und 290 nm erwähnt. LEDs zeichnen sich durch eine schmale Intensitätsverteilung (typischer Weise +/- 10 - 20 nm) aus. Sie haben keine nennenswerte Aufwärmphase und sind von ca. 10 bis 100% der Maximalintensität regelbar.

Mit UV-Leuchtdioden lassen sich Leistungswerte von einigen Watt/cm² erzielen, und der Wirkungsgrad liegt je nach LED-UV-System zwischen 1 und 20 %. Dabei kann die grobe Faustregel gelten: je kürzer die Wellenlänge, desto geringer der Wirkungsgrad. Je kürzer die Emissionswellenlänge sein soll, desto höher die Herstellkosten.

Gegenwärtig sind LED-Systeme für die Flächenhärtung kommerziell bei einer Wellenlänge von 395 nm mit einer UV-Leistung zwischen 1-4 W/cm² und bei einer Wellenlänge von 365 nm im Bereich von 0,5-2 W/cm² von verschiedenen Anbietern erhältlich.

Um schnellere Härtungsgeschwindigkeiten zu ermöglichen, steigern die Anbieter von LED-Einheiten derzeit die UV-Ausgangsleistung zu Lasten der Effizienz. Die gegenwärtig leistungsstärksten LED-Einheiten haben bei 395 nm eine Effizienz von ca. 8-12 %, wobei eine Quecksilber-Mitteldrucklampe bei 28 % Effizienz liegt. Die Effizienz einer 365 nm-LED-Einheit liegt derzeit unter 10 %.

LED-Arrays sind sehr teuer. Der aktuelle Preis für eine 8 x 1 cm-UV-LED-Array liegt bei 5000 - 6000 Euro. Bei Verdoppelung der Bahnbreite verdoppelt sich für ein LED-Aggregat auch die Zahl der LEDs und somit auch der Preis. Bei QuecksilberDampflampen fällt der Preisunterschied zwischen verschiedenen Lampenlängen geringer aus.

US 6,683,421 offenbart ein Gerät zur Fotovernetzung von fotoreaktiven Materialien umfassend (a) eine Einhausung, (b) ein an der Einhausung befestigtes, Licht emittierendes Halbleiter-Array, das in der Lage ist, Licht mit einer zur Auslösung von Fotoreaktionen geeigneten Wellenlänge zu emittieren, (c) eine Stromquelle zur Anregung des Arrays, Licht auszustrahlen, (d) eine an die Stromquelle gekoppelte Steuerungseinheit zur Regelung des von der Stromquelle an das Array gelieferten Stroms, wobei (e) das Array aus einer Mehrzahl von Licht emittierenden Halbleitern besteht, und (f) die Mehrzahl von Halbleitern in einer Mehrzahl von Gruppen organisiert ist. Es werden keine konkreten Einsatzzwecke für die beschriebene Vorrichtung genannt. US 6,931,992 offenbart ein System zur Belichtung eines fotopolymerisierbaren Elements mit UV-Licht, umfassend eine Drehvorrichtung zur rotativen Bewegung des Fotopolymers, und eine um die Drehvorrichtung angeordnete Strahlungsquellen-Baugruppe, wobei die Baugruppe wenigstens eine Strahlungsquelle umfasst, die mindestens zwei verschiedene Lichtemissionen auf das Fotopolymer abgeben kann und die zumindest teilweise quer zur Rotationsrichtung und entlang des Fotopolymers bewegt werden kann, wobei die verschiedenen Lichtemissionen so angeordnet sind, dass Ihre Strahlen einander überlappen, um alle Punkte auf der Oberfläche des Fotopolymers kontinuierlich mit mindestens einer Strahlungsquelle belichten zu können. Außerdem wird ein System zur Ablatierung einer flexographischen Druckplatte und Belichtung mit UV-Licht beschrieben. Als Strahlungsquellen werden Quecksilber-Plasmakapillarlampen konkret genannt.

WO 2008/135865 beschreibt ein Verfahren umfassend das Positionieren einer Druckplatte mit fotovernetzbarem Material auf einer Bebilderungseinheit, das Bebildern der Platte gemäß Bilddaten, die Anwendung von UV-Strahlung von mehreren UVemittierenden Dioden zur Vernetzung des fotovernetzbaren Materials auf der Platte während der Bebilderung der Druckplatte, wobei die Druckplatte eine fotopolymerisierbare Flexodruckplatte, eine fotopolymerisierbare Buchdruckplatte oder ein fotopolymerisierbarer Sleeve sein kann. Weiterhin wird beschrieben, die Platte von der Bebilderungseinheit zu entfernen und anschließend von der Rückseite bzw. von der Vorderseite und ggf. auch von der Rückseite mit UV-Strahlung von mehreren UVemittierenden Dioden zu belichten.

DE 20 2004 017 044 U1 offenbart eine Vorrichtung zur Belichtung von Siebdruckschablonen, Offsetdruckplatten, Flexodruckplatten oder dergleichen mit wenigstens einer Leuchte (1), mit einer transparenten Auflageplatte (8) für ein Belichtungsgut und einer Vorrichtung (10, 11) zum Hin- und Herbewegen der wenigstens einen Leuchte (1), wobei die wenigstens eine Leuchte (1) mit geringem Abstand zu der Auflageplatte (8) angeordnet ist, dadurch gekennzeichnet, dass die Leuchte (1) wenigstens eine UV-Licht abstrahlende Leuchtdiode (3) aufweist.

Während der Belichtung von Fotopolymerplatten mit UV-Licht durch eine durch Laserablation erzeugte Maske tritt als unerwünschter Effekt die Inhibierung der Polymerisation durch Sauerstoff dar, der aus der Umgebungsatmosphäre in die Fotopolymerschicht eindiffundiert. Der gleiche Effekt tritt auf, wenn eine mittels anderer Techniken digital bebilderbare Schicht eingesetzt wird, da diese Schichten im Allgemeinen nur einige Mikrometer dick und damit so dünn sind, dass der Sauerstoff aus der Umgebungsluft durch sie hindurch diffundieren kann.

Bei der Belichtung des Flexodruckelements durch eine fotografische Maske hindurch muss gewährleistet werden, dass das Negativ ohne Lufteinschlüsse gleichmäßig auf der Oberfläche des Flexodruckelements aufliegt, da es ansonsten zu Fehlbelichtungen ("Hohlkopien") kommen kann. Daher befindet sich auf der fotopolymerisierbaren Schicht üblicherweise eine Substratschicht, die weniger klebrig als die Oberfläche der fotopolymerisierbaren Schicht ist, andererseits werden meist Filmnegative mit mindestens einer rauen Filmseite verwendet. Durch das Anlegen von Vakuum (etwa mit Hilfe einer Vakuumfolie) wird schließlich der innige Kontakt zwischen Filmnegativ und Plattenoberfläche hergestellt, indem die dazwischen befindliche Luft weitestgehend entfernt wird. Somit kann der Sauerstoff nicht mehr die Fotopolymerisation inhibieren. Die am häufigsten verwendeten UV-Strahlquellen, nämlich UV/A-Röhren, besitzen ein sehr diffuses Licht. Begünstigt durch die niedrige UV-Intensität und die damit verbundene lange Belichtungsdauer spielt Streulicht eine deutliche Rolle. An der Vakuumfolie und an allen Grenzflächen (z.B. zwischen Filmnegativ und Plattenoberfläche) wird das UV/A-Licht gestreut. Hierdurch kann es leicht zu einer Verbreiterung von abzubildenden Positivelementen kommen, während feine Nichtbildbereichstrukturen verkleinert werden können.

Die Inhibierung der Polymerisation durch Sauerstoff kann andererseits zu einer starken Elementreduktion führen, da die Bildelemente zumindest an den Rändern nicht mehr ausreichend polymerisieren und diese im Zuge der bildmäßigen Entwicklung beispielsweise durch Lösemittel schließlich mit entfernt werden. Dies hat eine sogenannte Tonwertreduktion zur Folge, das heißt der auf der Druckplatte gemessene Tonwert eines Rasters von Positivelementen (Rasterpunkten) ist kleiner als es den Bilddaten entspricht. Dies kann unter Umständen erwünscht sein, um beispielsweise den Tonwertzuwachs im eigentlichen Druckprozess zu kompensieren, andererseits sind Rasterpunkte unterhalb eines bestimmten Tonwerts dann nicht mehr stabil versockelt und werden nicht mehr ausgebildet. Dadurch gehen Grauabstufungen verloren und man hat einen geringeren Tonwertumfang im Druck. Bekannt ist der Effekt der Tonwertreduktion bei der Belichtung von digitalen Flexodruckplatten nach dem Stand der Technik mit UV/A-Röhren. Durch den polymerisationsinhibierenden Effekt des Sauerstoffs während der Belichtung wird die Polymerisation der Rasterpunkte gestört, so dass die Rasterpunkte auf der Platte kleiner werden als in den Daten angelegt.

Aufgabe der Erfindung ist es, ein kostengünstiges Verfahren zur Herstellung von Flexodruckformen bereitzustellen, das den Nachteilen des Standes der Technik abhilft. Insbesondere soll der polymerisationsinhibierende Effekt des Sauerstoffs während der Belichtung der fotopolymerisierbaren Platte weitgehend und die damit verbundenen nachteiligen Auswirkungen auf das Druckergebnis unterdrückt werden.

Gelöst wird die Aufgabe durch ein Verfahren zur Herstellung von Flexodruckformen, bei dem man als Ausgangsmaterial ein fotopolymerisierbares Flexodruckelement einsetzt, welches übereinander angeordnet mindestens umfasst
- einen dimensionsstabilen Träger, und
- mindestens eine fotopolymerisierbare reliefbildende Schicht, mindestens umfassend ein elastomeres Bindemittel, eine ethylenisch ungesättigte Verbindung und einen Fotoinitiator,
- eine digital bebilderbare Schicht, die in direktem Kontakt mit der fotopolymerisierbaren reliefbildenden Schicht ist,
und das Verfahren mindestens die folgenden Schritte umfasst:
(a) Erzeugung einer Maske durch Bebilderung der digital bebilderbaren Schicht,
(b) Belichtung der fotopolymerisierbaren reliefbildenden Schicht durch die Maske hindurch mit aktinischem Licht und Fotopolymerisation der Bildbereiche der Schicht, und
(c) Entwicklung der fotopolymerisierten Schicht durch Auswaschen der nicht fotopolymerisierten Bereiche der reliefbildenden Schicht mit einem organischen Lösungsmittel oder durch thermische Entwicklung,
   dadurch gekennzeichnet, dass der Schritt (b) zwei Belichtungsschritte (b-1) und (b-2) umfasst, wobei in einem ersten Schritt (b-1) eine Belichtung mit aktinischem Licht mit einer Intensität von ≥ 100 mW/cm² aus einer Mehrzahl von UV-LEDs erfolgt und anschließend in einem zweiten Schritt (b-2) eine Belichtung mit aktinischem Licht mit einer Intensität von < 100 mW/cm² aus einer von UV-LEDs verschiedenen UV-Strahlungsquelle erfolgt.

Erfindungsgemäß wird unter Verwendung einer Mehrzahl von in einem Array angeordneten UV-LEDs für aktinisches Licht eine "Initialbelichtung" zur kopiergenauen Ausbildung von Elementen an der Oberfläche der fotopolymerisierbaren Platte durchgeführt. Die restliche "Ausbelichtung" zur Elementversockelung wird mit anderen, kostengünstigeren Strahlungsquellen, z.B. mit UVA-Röhren oder UV-Strahlern durchgeführt.

Bevorzugt wird der erste Belichtungsschritt mit einer Intensität von ≥ 150 mW/cm², besonders bevorzugt mit einer Intensität von ≥ 200 mW/cm², gemessen an der Oberfläche des Flexodruckelements, durchgeführt.

Es hat sich herausgestellt, dass die Reihenfolge der Belichtungsschritte wesentlich ist. So werden zufrieden stellende Ergebnisse nur erzielt, wenn zuerst eine Belichtung mit einer UV-Lichtquelle hoher Strahlungsintensität erfolgt und anschließend eine Belichtung mit einer kostengünstigeren UV-Lichtquelle niedrigerer Strahlungsintensität. Die umgekehrte Reihenfolge führt nicht zu befriedigenden Ergebnissen, da eine bereits stattgefundene Inhibierung der Polymerisation durch Sauerstoff auch durch nachfolgende Belichtung mit hochenergetischer UV-Strahlung nicht mehr umkehrbar ist, d.h. die Reproduktion erfolgt dann nicht mehr kopiergenau.

Wird die Belichtung ausschließlich unter Verwendung von UV-LEDs durchgeführt ergibt sich die Schwierigkeit, isolierte, feine Bildelemente stabil zu versockeln, da keine Verbreiterung der Bildelemente in tieferen Bereichen der fotopolymerisierbaren Schicht auftritt. Die Belichtung mit herkömmlichen UV-Strahlungsquellen hingegen führt zu einer breiteren Versockelung von isolierten Bildelementen (Punkte oder feine Linien), da das Licht von UV-Röhren oder UV-Strahlern diffuser und damit weniger gut gerichtet ist, was zu einer Verbreiterung der Bildelemente in den tiefer liegenden Bereichen der Fotopolymerschicht führt. Wird der inhibierende Effekt des Sauerstoffs an der Oberfläche mit Hilfe der Belichtung durch intensitätsstarken UV-LEDs minimiert, spielt er bei einer nachgeschalteten Belichtung mit UV-Röhren praktisch keine Rolle mehr. Die tiefer liegenden Bereiche der Fotopolymerschicht können dann anschließend mit einer herkömmlichen UV-Lichtquelle (UV-Röhre oder UV-Strahler) belichtet und dabei gut versockelt werden.

Im Allgemeinen beträgt die Intensität der erfindungsgemäß eingesetzten UV-LEDs ≥ 100 mW/cm², vorzugsweise ≥ 150 mW/cm², besonders bevorzugt ≥ 200 mW/cm², gemessen an der Oberfläche der Flexodruckplatte. Im Allgemeinen liegt diese Intensität nicht über 2000 mW/cm², bevorzugt nicht über 1000 mW/cm².

Zur Messung der Intensität auf Höhe der Plattenoberfläche wird ein geeignetes, kalibriertes UV-Messgerät verwendet, wobei der Sensor des Messgeräts im gleichen Abstand von der Strahlquelle platziert wird, den die Plattenoberfläche von der Strahlquelle haben würde. Geeignete UV-Messgeräte sind im Handel von verschiedenen Anbietern erhältlich. Wichtig hierbei ist, dass das Messgerät im zu prüfenden UV-Wellenlängebereich sensitiv und kalibriert ist.

Der Abstand zwischen Druckplattenoberfläche und UV-Strahlungsquelle beträgt im ersten Belichtungsschritt üblicher Weise 2 bis 20 mm, bevorzugt 2 bis 10 mm. Die Strahlung der LEDs weist praktisch keinen IR-Anteil auf, so dass eine hohe Intensität bei einem geringen Abstand zum Substrat möglich ist, ohne dass eine hohe Wärmebelastung des zu bestrahlenden Substrats auftritt.

Eine hohe UV-Intensität im ersten Belichtungsschritt (b-1) minimiert die O2-Inhibierung der Fotopolymerisation und damit das Ausmaß der Elementreduktion, d.h. es kommt nur noch zu einer sehr geringen Kopierverkleinerung der Bildelemente. Eine geringe Kopierverkleinerung kann wünschenswert sein, da es durch den Druckvorgang zu einem Tonwertzuwachs im Druck kommen kann.

Die Strahlungsdosis im ersten Belichtungsschritt (b-1) beträgt im Allgemeinen von 1 bis 8 J/cm², vorzugsweise von 1 bis 5 J/cm². Eine minimale UV-LED-Dosis ist erforderlich, da bei zu geringer UV-LED-Dosis nur die unmittelbare Oberfläche vernetzt wird, aber die den Elementsockel verbindenden Schichtanteile zu schwach vernetzt sind, was zu Ausbrüchen führen kann. Diese minimale UV-LED-Dosis liegt bei ca. 0,5 J/cm².

Im zweiten Belichtungsschritt (b-2) wird eine von UV-LEDs verschiedene UV-Strahlungsquelle mit geringerer Intensität eingesetzt. Geeignete, im zweiten Belichtungsschritt eingesetzte Strahlungsquellen emittieren UV/A-Licht, d. h. UV-Licht in einem Bereich von 315 - 420 nm. Im Allgemeinen weist das emittierte Licht eine breite Intensitätsverteilung auf. Geeignete, im zweiten Belichtungsschritt eingesetzte UV-Strahlungsquellen sind die vorstehend beschriebenen UV-Röhren und UV-Strahler. UV-Strahler werden wegen der höheren Wärmeentwicklung im Allgemeinen in größerem Abstand (typischer Weise 500 mm) von der Oberfläche der Flexodruckplatte eingesetzt als UV-Röhren (typischer Weise 50 mm).

Im Allgemeinen beträgt die Intensität der UV-Röhre ≥ 8 mW/cm², vorzugsweise ≥ 10 mW/cm², besonders bevorzugt ≥ 12 mW/cm². Die Intensität liegt im Allgemeinen nicht über 50 mW/cm², jeweils gemessen an der Oberfläche des Flexodruckelements. Beispielsweise beträgt die Intensität einer UV-Röhre 10 - 30 mW/cm², gemessen in 50 mm Abstand. Die Intensität eines UV-Strahlers beträgt beispielsweise 50 - 60 mW/cm², gemessen in 500 mm Abstand.

Die Strahlungsdosis im zweiten Belichtungsschritt (b-2) beträgt im Allgemeinen von 1 bis 15 J/cm², vorzugsweise von 2 bis 10 J/cm².

Im Allgemeinen werden 10 bis 80 % der Gesamtdosis im ersten Belichtungsschritt (b-1) und 20 bis 90 % der Gesamtdosis im zweiten Belichtungsschritt (b-2) appliziert. Bevorzugt werden 15 bis 50 der Gesamtdosis im ersten Belichtungsschritt (b-1) und 50 bis 85 % der Gesamtdosis im zweiten Belichtungsschritt (b-2) appliziert.

Geeignete LEDs, die im ersten Belichtungsschritt (b-1) eingesetzt werden können, sind die für die UV-Härtung bekannten und kommerziell erhältlichen LEDs. Diese weisen Emissionsmaxima im Wellenlängenbereich von 350 - 405 nm auf, beispielsweise bei 395 nm bzw. 365 nm. Weitere mögliche Emissionswellenlängen sind 350 nm, 375 nm, 385 nm und 405 nm. Bevorzugte erfindungsgemäß eingesetzte kommerzielle LED-Systeme sind solche mit einer Wellenlängen von 375 und 365 nm.

Erfindungsgemäß erfolgt der erste Belichtungsschritt (b-1) mit einer Mehrzahl von UV-LEDs, wobei diese im Allgemeinen in einem Array angeordnet sind. So kann ein derartiges Array aus einer Mehrzahl von nebeneinander angeordneten quadratischen LED-Modulen bestehen, wobei jedes der Module eine Mehrzahl, beispielsweise 5 x 5 einzelne LEDs umfasst.

Der erste Belichtungsschritt (b-1) kann auch mit mehreren derartiger LED-Arrays erfolgen.

Die Belichtung erfolgt im Allgemeinen derart, dass das fotopolymerisierbare Flexodruckelement unter den Belichtungseinheiten (LED-Array bzw. UV-Röhre oder UV-Strahler) hindurchtransportiert wird. Selbstverständlich können auch die Belichtungseinheiten bewegt werden.

Bei der Herstellung von zylindrischen Flexodruckformen können auch so genannte Rundbelichter eingesetzt werden, wobei diese dann ein oder mehrere LED-Arrays und ein oder mehrere UV-Röhren umfassen.

Im Allgemeinen wird eine Rückseitenvorbelichtung des Flexodruckelements durchgeführt. Dazu wird die Schicht aus fotopolymerisierbarem Material vor Durchführung von Schritt (b) von der Rückseite des fotopolymerisierbaren Flexodruckelements durch die UVtransparente Trägerfolie hindurch mit aktinischem Licht vorbelichtet. Die Rückseitenvorbelichtung wird vorzugsweise bei Flexodruckelementen mit einer Stärke von ≥ 1 mm durchgeführt, wobei diese Angabe sich auf die Summe aus dimensionsstabiler Trägerfolie und fotopolymerisierbarer Schicht bezieht.

Im Allgemeinen erfolgt die Rückseitenvorbelichtung mit einer UV-Röhre oder einem UV-Strahler, vorzugsweise des gleichen Typs, der auch im Belichtungsschritt (b-2) eingesetzt wird.

Das als Ausgangsmaterial eingesetzte fotopolymerisierbare Flexodruckelement umfasst übereinander angeordnet mindestens
- einen dimensionsstabilen Träger, und
- mindestens eine fotopolymerisierbare reliefbildende Schicht, mindestens umfassend ein elastomeres Bindemittel, eine ethylenisch ungesättigte Verbindung und einen Fotoinitiator,
- eine durch Laserablation digital bebilderbare Schicht.

Beispiele geeigneter dimensionsstabiler Träger für das als Ausgangsmaterial für das Verfahren eingesetzte fotopolymerisierbare Flexodruckelemente sind Platten, Folien sowie konische und zylindrische Röhren (Sleeves) aus Metallen wie Stahl, Aluminium, Kupfer oder Nickel oder aus Kunststoffen wie Polyethylenterephthalat (PET), Polyethylennaphthalat (PEN), Polybutylenterephthalat (PBT), Polyamid, Polycarbonat, gegebenenfalls auch Gewebe und Vliese, wie Glasfasergewebe sowie Verbundmaterialien, z.B. aus Glasfasern und Kunststoffen. Als dimensionsstabile Träger kommen vor allem dimensionsstabile Trägerfolien wie beispielsweise Polyesterfolien, insbesondere PET- oder PEN-Folien oder flexible metallische Träger, wie dünne Bleche oder Metallfolien aus Stahl, bevorzugt aus rostfreiem Stahl, magnetisierbarem Federstahl, Aluminium, Zink, Magnesium, Nickel, Chrom oder Kupfer in Betracht.

Soll eine Rückseitenvorbelichtung des Flexodruckelements durchgeführt werden, muss der dimensionsstabile Träger für UV-Licht transparent sein. Bevorzugte Träger sind Kunststofffolien aus PET oder anderen Polyestern.

Das Flexodruckelement umfasst weiterhin mindestens eine fotopolymerisierbare, reliefbildende Schicht. Die fotopolymerisierbare reliefbildende Schicht kann unmittelbar auf dem Träger aufgebracht sein. Zwischen dem Träger und der reliefbildenden Schicht können sich aber auch noch andere Schichten befinden, wie beispielsweise Haftschichten und/oder elastische Unterschichten.

Zwischen der gegebenenfalls mit einer Haftschicht beschichteten Trägerfolie und der fotopolymerisierbaren, reliefbildenden Schicht kann sich eine elastomere Trägerschicht befinden. Die Trägerschicht kann optional fotochemisch vernetzbar sein.

Die fotopolymerisierbare reliefbildende Schicht umfasst mindestens ein elastomeres Bindemittel, eine ethylenisch ungesättigte Verbindung, einen Fotoinitiator oder ein Fotoinitiatorsystem sowie optional eine oder mehrere weitere Komponenten, beispielsweise Weichmacher, Verarbeitungshilfsmittel, Farbstoffe und UV-Absorber.

Elastomere Bindemittel zur Herstellung von Flexodruckelementen sind dem Fachmann bekannt. Es können sowohl hydrophile als auch hydrophobe Bindemittel eingesetzt werden. Als Beispiele seien Styrol-Dien-Blockcopolymere, Ethylen-Acrylsäure-Copolymere, Polyethylenoxid-Polyvinylalkohol-Pfropfcopolymere, Naturkautschuk, Polybutadien, Polyisopren, Styrol-Butadien-Kautschuk, Nitril-Butadien-Kautschuk, ButylKautschuk, Styrol-Isopren-Kautschuk, Styrol-Butadien-Isopren-Kautschuk, Polynorbornen-Kautschuk oder Ethylen-Propylen-Dien-Kautschuk (EPDM) genannt. Bevorzugt werden hydrophobe Bindemittel eingesetzt. Derartige Bindemittel sind in organischen Lösemitteln löslich oder zumindest quellbar, während sie in Wasser weitgehend unlöslich sind und auch nicht oder zumindest nicht wesentlich in Wasser quellbar sind.

Bevorzugt handelt es sich bei dem Elastomer um ein thermoplastisch elastomeres Blockcopolymer aus Alkenylaromaten und 1,3-Dienen. Bei den Blockcopolymeren kann es sich sowohl um lineare, verzweigte oder radiale Blockcopolymere handeln. Üblicherweise handelt es sich um Dreiblockcopolymere vom A-B-A-Typ, es kann sich aber auch um Zweiblockpolymere vom A-B-Typ handeln, oder um solche mit mehreren alternierenden elastomeren und thermoplastischen Blöcken, z.B. A-B-A-B-A. Es können auch Gemische zweier oder mehrerer unterschiedlicher Blockcopolymere eingesetzt werden. Handelsübliche Dreiblockcopolymere enthalten häufig gewisse Anteile an Zweiblockcopolymeren. Die Dien-Einheiten können 1,2- oder 1,4-verknüpft sein. Es können sowohl Blockcopolymere vom Styrol-Butadien oder vom Styrol-Isopren-Typ, als auch vom Styrol-Butadien-Isopren-Typ eingesetzt werden. Sie sind beispielsweise unter dem Namen Kraton^{®} im Handel erhältlich. Weiterhin einsetzbar sind auch thermoplastisch elastomere Blockcopolymere mit Endblöcken aus Styrol und einem statistischen Styrol-Butadien-Mittelblock, die unter dem Namen Styroflex^{®} erhältlich sind. Die Blockcopolymere können auch ganz oder teilweise hydriert sein, wie beispielsweise in SEBS-Kautschuken.

Ganz besonders bevorzugt in der fotopolymerisierbaren reliefbildenden Schicht enthaltene elastomere Bindemittel sind Dreiblockcopolymere vom Typ A-B-A oder radiale Blockcopolymere vom Typ (AB)ₙ, worin A Styrol und B ein Dien sind.

Ganz besonders bevorzugt in einer elastomeren Trägerschicht enthaltene elastomere Bindemittel sind Dreiblockcopolymere vom Typ A-B-A, radiale Blockcopolymere vom Typ (AB)ₙ, worin A Styrol und B ein Dien sind, sowie statistische Copolymere und Random-Copolymere aus Styrol und einem Dien.

Selbstverständlich können auch Gemische mehrerer Bindemittel eingesetzt werden, vorausgesetzt, die Eigenschaften der reliefbildenden Schicht werden dadurch nicht negativ beeinflusst.

Die Gesamtmenge an Bindemitteln beträgt im Falle der reliefbildenden Schicht üblicherweise 40 bis 90 Gew.-% bezüglich der Summe aller Bestandteile der reliefbildenden Schicht, bevorzugt 40 bis 80 Gew.-% und besonders bevorzugt 45 bis 75 Gew.-%.

Im Falle einer gegebenenfalls vorhandenen elastomeren Trägerschicht kann die Gesamtmenge an elastomeren Bindemitteln bis zu 100 Gew.-% betragen. Üblicherweise beträgt sie 75 bis 100 Gew.-%, bevorzugt 85 bis 100 Gew.-% und besonders bevorzugt 90 bis 100 Gew.-%.

Die fotopolymerisierbare reliefbildende Schicht umfasst weiterhin in bekannter Art und Weise mindestens eine ethylenisch ungesättigte Verbindung, die mit den Bindemitteln verträglich ist. Geeignete Verbindungen weisen mindestens eine ethylenisch ungesättigte Doppelbindung auf und sind polymerisierbar. Diese werden daher nachfolgend als Monomere bezeichnet. Als besonders vorteilhaft haben sich Ester oder Amide der Acrylsäure oder Methacrylsäure mit mono- oder polyfunktionellen Alkoholen, Aminen, Aminoalkoholen oder Hydroxyethern und -estern, Ester der Fumar- oder Maleinsäure, Vinylether, Vinylester oder Allylverbindungen erwiesen. Beispiele für geeignete Monomere sind Butylacrylat, 2-Ethylhexylacrylat, Laurylacrylat, Tetradecylacrylat, 1,4-Butandioldiacrylat, 1,6-Hexandioldiacrylat, 1,6-Hexandioldimethacrylat, 1,9-Nonandioldiacrylat, Trimethylolpropantri(meth)acrylat, Dioctylfumarat und N-Dodecylmaleimid. Ganz besonders bevorzugte Monomere sind Mono-, Di- und Triacrylate sowie -methacrylate. Selbstverständlich können auch Gemische mehrerer verschiedener Monomere eingesetzt werden. Art und Menge der Monomeren werden vom Fachmann je nach den gewünschten Eigenschaften der Schicht gewählt. Die Menge an Monomeren beträgt in der fotopolymerisierbaren reliefbildenden Schicht a) im Regelfalle nicht mehr als 20 Gew.-% bzgl. der Menge aller Bestandteile, im Allgemeinen liegt sie zwischen 3 und 15 Gew.-%.

Die fotopolymerisierbare reliefbildende Schicht umfasst weiterhin in prinzipiell bekannter Art und Weise mindestens einen Fotoinitiator oder ein Fotoinitiatorsystem. Beispiele für geeignete Initiatoren sind Benzoin oder Benzoinderivate, wie Methylbenzoin oder Benzoinether, Benzilderivate, wie Benzilketale, Acylarylphosphinoxide, Acrylarylphosphinsäureester, α-Hydroxyketone, Mehrkernchinone oder Benzophenone. Die Menge an Fotoinitiator in der reliefbildenden Schicht beträgt in der Regel 0,1 bis 5 Gew.-% bezüglich der Menge aller Bestandteile der reliefbildenden Schicht.

Die elastomere Trägerschicht kann ebenfalls die genannten ethylenisch ungesättigten Verbindungen und die genannten Fotoinitiatoren enthalten, bevorzugt enthält sie diese, ist also wie die reliefbildende Schicht fotopolymerisierbar. Im Allgemeinen beträgt die Menge an ethylenisch ungesättigten Verbindungen in der Trägerschicht 0 bis 15 Gew.-%. Im Allgemeinen beträgt die Menge an Fotoinitiator in der Trägerschicht 0 bis 5 Gew.-%.

Die reliefbildende Schicht und gegebenenfalls die optionale elastomere Trägerschicht können Weichmacher enthalten. Es können auch Gemische verschiedener Weichmacher eingesetzt werden. Beispiele für geeignete Weichmacher umfassen modifizierte und unmodifizierte Naturöle und -harze, wie hochsiedende paraffinische, naphthenische oder aromatische Mineralöle, synthetische Oligomere oder Harze wie Oligostyrol, hochsiedende Ester, oligomere Styrol-Butadien-Copolymere, oligomere α-Methylstyrol/p-Methylstyrol-Copolymere, flüssige Oligobutadiene, insbesondere solche mit einem Molekulargewicht zwischen 500 und 5000 g/mol, oder flüssige oligomere AcrylnitrilButadien-Copolymere oder oligomere Ethylen-Propylen-Dien-Copolymere. Bevorzugt sind Polybutadienöle, insbesondere solche mit einem Molekulargewicht zwischen 500 und 5000 g/mol, hochsiedende aliphatische Ester wie insbesondere Alkylmono- und dicarbonsäureester, beispielsweise Stearate oder Adipate, und Mineralöle. Die Menge eines optional vorhandenen Weichmachers wird vom Fachmann je nach den gewünschten Eigenschaften der Schicht bestimmt. Sie wird im Regelfalle 50 Gew.-% der Summe aller Bestandteile der fotopolymerisierbaren reliefbildende Schicht nicht übersteigen, im Allgemeinen beträgt sie 0 bis 50 Gew.-%, bevorzugt 0 bis 40 Gew.-%.

Die Dicke der reliefbildenden Schicht beträgt im Allgemeinen 0,3 bis 7 mm, bevorzugt 0,5 bis 6 mm.

In einer bevorzugten Ausführungsform wird ein Bindemittel vom Styrol-Butadien-Typ eingesetzt. Besonders bevorzugte Bindemittel sind lineare, radiale oder verzweigte Blockcopolymere vom Styrol-Butadien-Typ. Diese Blockcopolymere haben ein mittleres Molekulargewicht M_{w} (Gewichtsmittel) von 80 000 bis 250 000 g/mol, bevorzugt 80 000 bis 150 000 g/mol, und besonders bevorzugt von 90 000 bis 130 000 g/mol und weisen einen Styrolgehalt von 20 bis 40 Gew.-%, bevorzugt 20 bis 35 Gew.-% und besonders bevorzugt von 20 bis 30 Gew.-% auf.

In einer weiteren bevorzugten Ausführungsform der Erfindung handelt es sich um ein Bindemittel vom Styrol-Isopren-Typ. Bevorzugte Bindemittel vom Styrol-Isopren-Typ enthalten in der Regel 13 bis 40 Gew.-%, bevorzugt 13 bis 35 Gew.-% und besonders bevorzugt von 14 bis 30 Gew.-% Styrol.

Die fotopolymerisierbaren Flexodruckelemente lassen sich nach dem Fachmann prinzipiell bekannten Methoden herstellen, beispielsweise durch Schmelzextrusion, Gießen oder Laminieren in einem einstufigen oder mehrstufigen Produktionsprozess. Bevorzugt ist die Herstellung mittels Schmelzextrusion, bei dem man zunächst die Bestandteile der reliefbildenden Schicht in einem Extruder unter Erwärmen miteinander mischt. Zur Herstellung von flächenförmigen Flexodruckelementen kann die fotopolymerisierbare Masse aus dem Extruder durch eine Breitschlitzdüse zwischen zwei Folien ausgetragen und der Schichtenverbund kalandriert werden, wobei sich die Art der Folien nach dem gewünschten Verwendungszweck richtet. Es kann sich hierbei um Folien handeln, welche eine gute Haftung mit der fotopolymerisierbaren Schicht aufweisen oder um leicht abziehbare (temporäre) Folien. Zur Herstellung von flächenförmigen Flexodruckelementen wird üblicherweise eine gut haftende Trägerfolie und eine abziehbare Deckfolie eingesetzt. Die Dicke der fotopolymerisierbaren Schicht beträgt im Allgemeinen 0,4 bis 7 mm, bevorzugt 0,5 bis 4 mm und besonders bevorzugt 0,7 bis 2,5 mm.

Die Bebilderung der digital bebilderbaren Schicht wird mittels digitaler Masken vorgenommen. Derartige Masken sind auch als In-situ-Masken bekannt. Hierzu wird zunächst eine digital bebilderbare Schicht auf die fotopolymerisierbare, reliefbildende Schicht aufgebracht. Bevorzugt handelt es sich bei der digital bebilderbaren Schicht um eine IR-ablative Schicht, Ink-Jet-Schicht oder thermografisch beschreibbare Schicht.

Bevorzugt ist die digital bebilderbare Schicht eine mit einem IR-Laser ablatierbare (IR-ablative) Schicht.

IR-ablative Schichten bzw. Masken sind für die Wellenlänge des aktinischen Lichtes opak und umfassen üblicherweise mindestens ein Bindemittel, einen IR-Absorber wie beispielsweise Ruß sowie einen Absorber für UV-Strahlung, wobei die Funktion des IR-Absorbers und UV-Absorbers auch von nur einem Stoff ausgeübt werden kann, was beispielsweise bei der Verwendung von Ruß als IR-Absorber der Fall ist, da Ruß in ausreichender Konzentration die Maskenschicht für UV-Licht im wesentlichen undurchlässig macht. In die IR-ablative Schicht kann mittels eines IR-Lasers eine Maske eingeschrieben werden, d.h. die Schicht wird an den Stellen, an denen sie vom Laserstrahl getroffen wird, zersetzt und abgetragen. Durch die entstandene Maske hindurch kann bildmäßig mit aktinischem Licht bestrahlt. werden. Beispiele für die Bebilderung von Flexodruckelementen mit IR-ablativen Masken sind beispielweise in EP-A 654 150 oder EP-A 1 069 475 offenbart.

Bei Ink-Jet-Schichten wird eine mit Ink-Jet-Tinten beschreibbare Schicht, beispielsweise eine Gelatine-Schicht aufgetragen. Diese ist mittels Ink-Jet-Druckern bebilderbar. Beispiele sind in EP-A 1 072 953 offenbart.

Bei thermografischen Schichten handelt es sich um Schichten, die Substanzen enthalten, die sich unter dem Einfluss von Hitze schwarz färben. Derartige Schichten umfassen beispielsweise ein Bindemittel und ein organisches Silbersalz und können mittels eines Druckers mit Thermokopf oder mittels IR-Lasern bebildert werden. Beispiele sind in EP-A 1 070 989 offenbart.

In einer besonderen Ausführungsform des erfindungsgemäßen Verfahrens ist zwischen der fotopolymerisierbaren reliefbildenden Schicht und der digital bebilderbaren Schicht eine raue UV-durchlässige Schicht vorgesehen, die eine partikuläre Substanz enthält. Durch die partikuläre Substanz werden in der druckenden Oberfläche kleine Erhebungen oder Vertiefungen erzeugt, die im Druckprozess den Farbübertrag verbessern.

Somit umfasst das Flexodruckelement übereinander angeordnet mindestens
- einen dimensionsstabilen Träger, und
- mindestens eine fotopolymerisierbare reliefbildende Schicht, mindestens umfassend ein elastomeres Bindemittel, eine ethylenisch ungesättigte Verbindung und einen Fotoinitiator,
- eine raue UV-durchlässige Schicht, mindestens umfassend eine partikuläre Substanz,
- eine digital bebilderbare Schicht.

Die in der UV-durchlässigen Schicht vorhandene partikuläre Substanz wird entweder in der reliefbildenden Schicht verankert und erzeugt so Erhebungen auf der reliefbildenden Schicht, oder die partikuläre Substanz wird nicht verankert und hinterlässt in der reliefbildenden Schicht Vertiefungen in der Größenordnung des Teilchendurchmessers der partikulären Substanz. Im Allgemeinen weist die partikuläre Substanz einen mittleren Teilchendurchmesser von 0,5 bis 50 µm auf.

Die raue UV-durchlässige Schicht befindet sich in direktem innigen Kontakt mit der fotopolymerisierbaren Reliefschicht, wodurch die Rauheit auf die druckende Oberfläche des Flexodruckelements übertragen wird.

In einer ersten Ausführungsform umfasst die raue Substratschicht
a) mindestens ein polymeres Bindemittel, und
b) mindestens eine partikuläre Substanz mit einem mittleren Teilchendurchmesser von 0,5 - 50 µm.

Wird das Flexodruckelement mittels eines Auswaschmittels entwickelt, wobei die Nichtbildbereiche des Flexodruckelements mit einem geeigneten Lösemittel oder Lösemittelgemisch entfernt werden, ist das polymere Bindemittel im Auswaschmittel löslich oder zumindest dispergierbar. Wird die Entwicklung des Flexodruckelements thermisch vorgenommen, wobei die Nichtbildbereiche soweit verflüssigt werden, dass sie durch ein geeignetes absorbierendes Material aufgenommen werden, lässt sich das polymere Bindemittel bei der Verarbeitungstemperatur soweit verflüssigen, dass es fließfähig wird und von dem absorbierenden Material aufgenommen werden kann. Geeignete Bindemittel umfassen Polyamide, z.B. Nylon und Nylon-Copolymere, Polyvinylalkohole, Polyurethane, Urethan-Copolymere, Polyvinylpyrrolidon, Polyethylenoxide mit einem zahlenmittleren Molekulargewicht von ≥ 100.000 g/mol, Ethylen-VinylacetatCopolymere, Polyacrylate, Polyester, Celluloseester, Celluloseether und Polyolefine.

Die partikuläre Substanz kann entweder durch Abdruck Vertiefungen in der fotopolymerisierbaren Reliefschicht erzeugen, oder sie kann, indem sie auf der fotopolymerisierbaren Reliefschicht verankert wird, Erhebungen auf der fotopolymerisierbaren Reliefschicht ausbilden.

Die Verankerung der partikulären Substanz auf der fotopolymerisierbaren Reliefschicht kann physikalisch oder chemisch erfolgen. Eine physikalische Verankerung kann z.B. dadurch bewirkt werden, dass die partikuläre Substanz eine sehr unregelmäßige Form aufweist oder viele offene kleine Poren besitzt. Die fotopolymerisierbare Schicht kann dann, während sie mit der rauen UV-durchlässigen Schicht in direktem Kontakt steht, in die Hohlräume oder Poren der partikulären Substanz eindringen, wodurch nach Polymerisation eine mechanische Verankerung bewirkt wird. Eine chemische Verankerung der partikulären Substanz auf der fotopolymerisierbaren Reliefschicht kann beispielsweise durch funktionelle Gruppen an der Partikeloberfläche bewirkt werden. Geeignete funktionelle Gruppen umfassen ethylenisch ungesättigte Gruppen oder andere mit Radikalen reaktionsfähige Gruppen wie Allylgruppen, Aminogruppen, Vinylsilangruppen, Vinylsiloxangruppen oder Halogengruppen.

Wie in EP 1457823 A2 beschrieben, besitzt die partikuläre Substanz im Regelfall eine mittlere Teilchengröße von ≥ 3 µm nach ASTM D 4483-85. Vorzugsweise weisen ≥ 60 Gewichtsprozent der partikulären Substanz eine Teilchengröße von 3 bis 15 µm auf.

Das Gerüst der partikulären Substanz ist vorzugsweise anorganischer Natur. Geeignete partikuläre Substanzen umfassen Mattierungsmittel mit
i) einem Porenvolumen von ≥ 0,9 ml/g oder
ii) einer BET-Oberfläche von ≥ 150 m²/g oder
iii) einer Ölzahl von ≥ 150 g / 100g,
wobei auch zwei oder drei der genannten Bedingungen erfüllt sein können. Weiterhin geeignete partikuläre Substanzen sind Kieselsäuren und Kieselgele, feindisperses Siliziumdioxid, Zeolithe und Pigmente in den beschrieben Teilchengrößen.

Zur Verankerung der partikulären Substanz auf der Oberfläche der fotopolymerisierbaren Schicht können die genannten geeigneten Substanzen mit den bereits erwähnten funktionellen Gruppen funktionalisiert sein, wobei die Funktionalisierung im Regelfall nur auf der Oberfläche der Partikel vorliegt.

In einer zweiten Ausführungsform umfasst die raue UV-durchlässige Schicht neben der partikulären Substanz mindestens ein Wachs. Die raue Substratschicht wird in diesem Fall in vorteilhafter Weise durch Aufbringen einer polymeren Wachsdispersion auf die digital bebilderbare Schicht hergestellt. Vorzugsweise wird dem Wachs kein weiteres Bindemittel zugesetzt.

Zwischen der digital bebilderbaren Schicht und der rauen UV-durchlässigen Schicht können sich ggf. noch Zwischenschichten befinden, z.B. eine haftvermittelnde Schicht.

Bei der nach dem Stand der Technik üblichen Belichtung eines digital bebilderten Flexodruckelements, welches eine zusätzliche raue UV-durchlässigen Schicht aufweist, mit UV-Röhren oder UV-Strahlern wirkt sich der vorhandene, in die fotopolymerisierbare reliefbildende Schicht eindiffundierende Sauerstoff inhibierend auf die Polymerisation aus, und zwar am stärksten direkt unterhalb der Oberfläche des Flexodruckelements. Insbesondere wird ein oberer Schichtbereich bis zu etwa 30 µm Tiefe des Flexodruckelements unvollständig polymerisiert und bei der anschließenden Entwicklung durch Auswaschen mit Lösungsmitteln wie auch durch thermische Entwicklung mit den Nichtbildbereichen entfernt. Hierdurch geht die auf die druckende Oberfläche abgebildete Rauheit der rauen UV-durchlässigen Schicht, welche in Form von Vertiefungen oder in Form verankerter Partikel vorliegt, weitgehend verloren. Auf der druckenden Oberfläche verbleiben dann nur noch sehr flache Strukturen, die würmchenartig aussehen können und deren Dimensionen nicht mehr mit den definierten Teilchengrößen der partikulären Substanz übereinstimmen.

Wendet man das erfindungsgemäße Belichtungsverfahren an, wird durch die hohe Intensität des ersten Belichtungsschrittes die inhibierende Wirkung des Sauerstoffs zumindest stark reduziert. Dadurch bleibt die durch die raue UV-durchlässige Schicht auf die Oberfläche der fotopolymerisierbaren reliefbildenden Schicht aufgebrachte Rauhigkeit im Wesentlichen erhalten. Eine gleichmäßig raue Oberfläche der druckenden Bereiche wirkt sich hinsichtlich Gleichmäßigkeit und Menge der auf den Bedruckstoff übertragenen Farbe vorteilhaft aus (Erhöhung der sog. Volltondichte).

Das erfindungsgemäße Verfahren kann durchgeführt werden, indem das Ausgangsmaterial zunächst in eine Aufnahmeeinheit eingelegt wird, beispielsweise durch Auflegen auf ein Förderband oder Bestücken des Magazins. Falls das Ausgangsmaterial eine Schutzfolie aufweist, muss diese für den Fall, dass die Aufnahmeeinheit keine automatische Abzugsvorrichtung aufweist, abgezogen werden.

In dem Verfahrensschritt (a) wird die digital bebilderbare Schicht in einer Bebilderungseinheit mittels der jeweils erforderlichen Technik bebildert. Die Bildinformationen werden direkt einer Steuerungseinheit entnommen.

In dem Verfahrensschritt (b) wird das bebilderte Flexodruckelement mittels der Belichtungseinheit durch die erzeugte Maske hindurch mittels aktinischem, also chemisch wirksamem Lichts bestrahlt.

In einem Verfahrensschritt (c) wird das bildmäßig bebilderte und belichtete Flexodruckelement mittels eines geeigneten Lösemittels oder einer Lösemittelkombination entwickelt. Hierbei werden die nicht belichteten, d.h. die von der Maske abgedeckten Bereiche der Reliefschicht entfernt, während die belichteten, d.h. die vernetzten Bereiche erhalten bleiben. Außerdem werden die Reste der digital bebilderbaren Schicht entfernt.

Das verwendete Lösungsmittel bzw. Lösungsmittelgemisch richtet sich nach der Art des eingesetzten Flexodruckelementes. Falls das Flexodruckelement eine wässrig entwickelbare fotopolymerisierbare Schicht aufweist, können Wasser oder überwiegend wässrige Lösemittel eingesetzt werden. Für den Fall organisch enfinrickelbarer Flexodruckelemente eignen sich insbesondere die bekannten Auswaschmittel für Flexodruckplatten, die üblicherweise aus Gemischen verschiedener organischer Lösungsmittel bestehen, die auf geeignete Art und Weise zusammenwirken. Beispielsweise können Entwickler aus naphthenischen oder aromatischen Erdölfraktionen im Gemisch mit Alkoholen, beispielsweise Benzylalkohol, Cyclohexanol oder aliphatische Alkohole mit 5 bis 10 Kohlenstoffatomen, sowie ggf. weiteren Komponenten, wie beispielsweise alicyclischen Kohlenwasserstoffen, Terpen-Kohlenwasserstoffen, substituierten Benzolen, beispielsweise Diisopropylbenzol, Estern mit 5 bis 12 Kohlenstoffatomen oder Glykolethern eingesetzt werden. Geeignete Auswaschmittel sind beispielsweise in EP-A 332 070 oder EP-A 433 374 offenbart.

Der Entwicklungsschritt wird üblicherweise bei Temperaturen oberhalb 20°C durchgeführt. Aus Sicherheitsgründen und zur Reduktion des apparativen Aufwands beim Entwicklungsgerät sollte die Temperatur bei der Verwendung organischer Lösemittel 5°C bis 15°C unter dem Flammpunkt des eingesetzten Auswaschmittelgemisches liegen.

Eine Trocknung der Flexodruckplatten kann in einem Verfahrensschritt (d) erfolgen. Weist das Flexodruckelement einen Träger aus einer PET-Folie auf, erfolgt eine Trocknung vorzugsweise bei einer Temperatur von 40 bis 80°C, besonders bevorzugt bei 50 bis 70°C. Handelt es sich bei dem dimensionsstabilen Träger des Flexodruckelements um einen Metallträger, kann die Trocknung auch bei höheren Temperaturen bis zu etwa 160°C erfolgen.

Die erhaltenen Flexodruckplatten können in einem Verfahrensschritt (e) bei Bedarf noch einer entklebenden Nachbehandlung durch mit UV-A- und/oder UV-C-Licht unterzogen werden. Im Regelfalle ist ein solcher Schritt empfehlenswert. Wenn die Bestrahlung mit Licht unterschiedlicher Wellenlänge vorgesehen ist, kann sie gleichzeitig oder auch nacheinander erfolgen.

Zwischen den einzelnen Verfahrensschritten wird das Flexodruckelement bzw. die Flexodruckplatte von einer Einheit zur nächsten weiter transportiert. Das Flexodruckelement bzw. die Flexodruckplatte muss in keinem der Verfahrensschritte gebogen werden, sondern alle Schritte werden mit dem ebenen Flexodruckelement -bzw. der ebenen Platte durchlaufen.

Die Entwicklung kann auch thermisch erfolgen. Bei der thermischen Entwicklung wird kein Lösemittel eingesetzt. Stattdessen wird die reliefbildende Schicht nach der bildmäßigen Belichtung mit einem absorbierenden Material in Kontakt gebracht und erwärmt. Bei dem absorbierenden Material handelt es sich beispielsweise um ein poröses Vlies, beispielsweise aus Nylon, Polyester, Cellulose oder anorganischen Materialien. Im Zuge der thermischen Entwicklung erfährt das Flexodruckelements zumindest an der Oberfläche eine derartige Temperaturerwärmung, dass sich die nicht polymerisierten Anteile der reliefbildenden Schicht verflüssigen und vom absorbierenden Material aufgenommen werden können. Das verbrauchte absorbierende Material wird anschließend entfernt. Einzelheiten zur thermischen Entwicklung sind beispielsweise von US 3,264,103, US 5,175,072, WO 96/14603 oder WO 01/88615 offenbart. Die Maske kann gegebenenfalls vorher mittels eines geeigneten Lösemittels oder ebenfalls thermisch entfernt werden.

Gegenstand der vorliegenden Erfindung ist auch eine Vorrichtung zur in-line-Produktion von Flexodruckplatten mittels digitaler Bebilderung, welche mindestens umfasst:
(A) optional eine Einheit zur digitalen Bebilderung des Flexodruckelements,
(B) eine erste Belichtungseinheit, umfassend eine Mehrzahl von in einem Array angeordneten LEDs, welche UV-Licht mit einer Intensität von ≥ 100 mW/cm² zu emittieren imstande sind,
(C) eine zweite Belichtungseinheit, umfassend mindestens eine von LEDs verschiedene UV-Strahlungsquelle, bevorzugt eine UV-Röhre oder einen UV-Strahler,
(D) eine Auswascheinheit,
(E) eine Trocknungseinheit,
(F) eine optionale Nachbehandlungseinheit,
(G) optional eine Ausgabeeinheit für die erhaltenen Flexodruckplatten, sowie
(H) Transporteinheiten für die Flexodruckelemente bzw. -formen, die mindestens die Einheiten (B) bis (E) miteinander verbinden.

Vorzugsweise sind die Einheiten (A) bis (H) so ausgelegt, dass die Flexodruckelemente bzw. -platten in ebenem Zustande verarbeitet werden.

Einheit (A) dient zur digitalen Bebilderung des Flexodruckelementes. Sie kann mehrere gleichartige Funktionseinheiten, beispielsweise IR-Laser oder Tintenstrahldruckköpfe zur digitalen Bebilderung umfassen. Es kann sich beispielsweise um 5 bis 50 Funktionseinheiten handeln. Durch das Zusammenwirken einer größeren Zahl von Funktionseinheiten kann eine schnellere Bebilderung des Flexodruckelementes erreicht werden. Durch die Einwirkung der Funktionseinheiten auf die digital bebilderbare Schicht des Flexodruckelementes wird eine Maske auf dem Flexodruckelement erzeugt. Häufig wird dieser Schritt separat in einer von der Vorrichtung mit den Einheit (B) bis (H) getrennten Einheit durchgeführt.

Die Funktionseinheiten sind üblicherweise oberhalb des Flexodruckelementes angeordnet, so dass sie die digital bebilderbare Schicht möglichst senkrecht von oben bebildern können. Zur Bebilderung muss weiterhin eine Relativbewegung zwischen den Funktionseinheiten und dem zu bebildernden Flexodruckelement erfolgen können. Hierzu können die Platte, die Funktionseinheiten oder beides bewegt werden. Es könnte sich aber beispielsweise auch um eine stationäre Laserquelle handeln, bei der nur der Laserstrahl, bspw. über ein System von Spiegeln gelenkt wird.

Die Art der Funktionseinheiten richtet sich nach der Art der digital bebilderbaren Schicht. Zur Bebilderung von Flexodruckelementen mit opaken, IR-ablativen Schichten werden IR-Laser eingesetzt. Bevorzugt handelt es sich hierbei um Diodenlaser, ohne dass die Erfindung darauf beschränkt sein soll. Hierbei wird die opake, IR-ablative Schicht an den Stellen, an denen sie von einem Laserstrahl getroffen wird, entfernt und die darunter liegende fotopolymerisierbare Schicht freigelegt. Um zu verhindern, dass die erfindungsgemäße Vorrichtung mit den Abbauprodukten der Schicht verunreinigt wird, sollte die Bebilderungseinheit bei dieser Ausführungsform zweckmäßigerweise eine Absaugvorrichtung aufweisen

Die Bebilderung mittels Ink-Jet-Technik erfolgt nach dem umgekehrten Prinzip. Die digital bebilderbare Schicht ist transparent und diejenigen Stellen, die nicht vernetzen sollen, werden mit opaker Tinte abgedeckt. Bei den Funktionseinheiten handelt es sich dementsprechend um Ink-Jet-Druckköpfe.

Thermografische, digital bebilderbare Schichten sind transparent und werden unter dem Einfluss von Wärme opak. Geeignete Funktionseinheiten zum Beschreiben thermografischer Schichten sind beispielsweise IR-Laser oder Thermodruckköpfe.

Zweckmäßigerweise ist die Bebilderungseinheit (A) modular aufgebaut, so dass die Funktionseinheiten je nach der gewünschten Bebilderungstechnik leicht ausgetauscht werden können.

Die erste Belichtungseinheit (B) umfasst eine Mehrzahl von in einem Array angeordneten LEDs. Sie kann mehrere Arrays von LEDs umfassen.

Die zweite Belichtungseinheit (C) umfasst mindestens eine UV-Röhre oder einen UV-Strahler der vorstehend beschriebenen Art.

Die Auswascheinheit (D) umfasst Mittel, um das belichtete Flexodruckelement mit einem geeigneten Auswaschmittel zu behandeln, beispielsweise durch Besprühen oder Eintauchen. Sie umfasst weiterhin üblicherweise bewegte Bürsten oder Vliese, um das Entfernen des nicht polymerisierten Polymers zu beschleunigen. Weiterhin umfasst die Auswascheinheit üblicherweise geeignete Mittel zur Zufuhr von frischem Auswaschmittel und zum Entfernen von verbrauchtem Auswaschmittel.

Die Trockeneinheit (E) dient zum Trocknen des feuchten Flexodruckelementes. Sie kann beispielsweise aus einer beheizbaren Kammer oder einem Trockenkanal bestehen. Die Wärmezufuhr kann beispielsweise über eingebaute Heizelemente erfolgen. Die Trockeneinheit kann aber auch vorteilhaft von einem warmen Trockengasstrom durchströmt werden. Selbstverständlich können die Beheizungsmöglichkeiten auch miteinander kombiniert werden. Als Trockner sollte ein Ablufttrockner verwendet werden, um die Lösemittelanreicherung im Gasraum zu unterdrücken. Die Lösemittelkonzentration im Gasraum sollte unterhalb der unteren Explosionsgrenze liegen. Vorteilhaft kann auch ein Trockengasstrom im Kreis geführt werden, wobei aus der Flexodruckplatte entwichenes Auswaschmittel in einer dazu geeigneten Vorrichtung abgetrennt wird und der abgereicherte Trockengasstrom wieder in die Trockeneinheit rückgeführt wird. Das Abtrennen des Lösemittels kann beispielsweise durch Kondensation bei tieferen Temperaturen oder Absorption an geeigneten Absorbern erfolgen.

Die Nachbehandlungseinheit (F) ist nicht in jedem Falle erforderlich, sie ist daher nur optional. Sie ist aber zur oberflächlichen Entklebung der erhaltenen Flexodruckplatte im Regelfalle empfehlenswert. Die Nachbehandlungseinheit umfasst geeignete Strahlungsquellen zur Bestrahlung der Flexodruckplatte mit UV-A- und/oder UV-C-Licht.

Die Ausgabeeinheit (G) dient zum Ausgeben der fertigen Flexodruckplatte. Im einfachsten Fall kann es sich dabei um eine einfache Ausgabevorrichtung handeln, der die Flexodruckplatten manuell entnommen werden. Beispielsweise können die Flexodruckplatten auf einem Förderband aus der Nachbehandlungseinheit (F) herausgefahren werden. Die Ausgabeeinheit (G) kann aber auch ein Magazin umfassen, welches eine größere Menge von fertiggestellten Flexodruckelementen aufnehmen kann.

Die Transporteinheiten (H) verbinden mindestens die Einheiten (B) bis (E), bei Bedarf aber auch alle Einheiten (A) bis (G) miteinander, und sorgen für den Transport der Flexodruckelemente - bzw. platten von einer Einheit zur nächsten. Es ist denkbar, dass die Flexodruckelemente bzw. -platten auf einer einzigen Transportvorrichtung durch die gesamte erfindungsgemäße Vorrichtung hindurchgefahren werden. Bei der Transportvorrichtung kann es sich beispielsweise um ein Transportband handeln, auf das ein Flexodruckelement aufgelegt wird und mittels geeigneter Haltevorrichtungen, beispielsweise Stiften auf dem Band festgehalten und befördert wird. Alternativ kann der Transport des Flexodruckelements auch mit Hilfe einer sog. Transportleiste vorgenommen werden. Als Transportleiste wird eine starre Haltevorrichtung bezeichnet, an welcher das Flexodruckelement für den Transport fixiert wird. Die Fixierung kann z. B. dadurch erfolgen, dass man in das Flexodruckelement zunächst Löcher stanzt, welche das Flexodruckelement mit Hilfe von auf der Transportleiste angebrachten Metallstiften in Position halten. Auch die Verwendung eines Klemmmechanismus an der Transportleiste ist möglich. Die Transportleiste wird durch die gesamte erfindungsgemäße Vorrichtung transportiert und nimmt dabei das Flexodruckelement mit. Die Transportleiste kann vorteilhaft mittels angetriebener Gewindestangen durch die gesamte erfindungsgemäße Vorrichtung hindurch transportiert werden, wenn an den äußeren Seiten der Transportleiste zur Gewindestange formschlüssige Konturen vorhanden sind.

Die Erfindung wird durch die nachfolgenden Beispiele näher erläutert.

### Beispiele

### Eingesetzte Flexodruckplatten

Bei den in den nachfolgenden Beispielen verwendeten Flexodruckplatten handelte es sich um kommerziell erhältliche, sog. digitale Flexodruckplatten der Marke nyloflex^{®} (Flint Group), die unter dem Produktnamen ACE 114 D sowie FAC 470 D vermarktet werden.

Digitale Flexodruckplatten umfassen übereinander angeordnet mindestens
a) einen dimensionsstabilen Träger (hier eine PET-Folie)
b) eine lichtempfindliche elastomere Schicht, die mit Hilfe aktinischer Strahlung bildmäßig vernetzt werden kann
c) eine Maskenschicht, welche für UV-Licht im Wesentlichen undurchlässig ist, wobei auch noch weitere Zwischenschichten zum Einsatz kommen können, wie beispielsweise eine haftvermittelnde Schicht zwischen a) und b).

### Vorbelichtung der Flexodruckplatten

Üblicherweise werden Flexodruckplatten mit UV-durchlässigen Trägern ab einer Stärke von mindestens 1 mm vollflächig von der Rückseite vorbelichtet, um einen flächigen polymerisierten Bereich zu erzeugen, der die Relieftiefe der Nichtbildbereiche auf ein gewünschtes Maß einstellt. Dadurch werden feine isolierte Positivelemente besser versockelt und daher auch stabiler im Druckprozess. Flexodruckplatten der Stärke 1,14 mm werden üblicherweise rückseitig so lange mit UV-Licht vorbelichtet, dass die Relieftiefe in den Nichtbildbereichen 0,5 bis 0,7 mm beträgt.

Vor dem Schritt der Maskenbebilderung wurden die in den Beispielen verwendeten Flexodruckplatten rückseitig mit UV-Licht für die in Tabelle 1 angegebene Zeit vorbelichtet, um eine Relieftiefe von ca. 0,7 mm einzustellen.

### Digitale Bebilderung der Flexodruckplatten

Für alle in den Beispielen genannten Versuche wurden die verwendeten digitalen Flexodruckplatten mit einem Testmotiv bebildert, welches verschiedene Testelemente enthält, unter anderem mehrere Rastertonwerte in unterschiedlichen Rasterweiten und feine Linien, Schriften, Negativpunkte sowie negative Linien und Schriften in variablen Dimensionen.

Die Bebilderung der digitalen Maske wurde mit Hilfe eines Ablationslasersystems "nano" der Firma Flexolaser GmbH vorgenommen, wobei die verwendete Maskenauflösung 2540 dpi betrug.

### Entwicklung von Flexodruckplatten

Die lösemittelbasierte Entwicklung der bildmäßig belichteten Flexodruckplatten wurde bei der jeweils angegebenen Auswaschgeschwindigkeit und mit der für den jeweiligen Produkttyp empfohlenen Bürstenstellung mit Hilfe eines nyloflex^{®} F III-Auswaschgeräts durchgeführt. Als Auswaschmittel wurde nylosolv® A eingesetzt.

Nach dem Auswaschprozess wurden die noch lösemittelhaltigen Platten laut den produktspezifischen Empfehlungen bei 60-65°C getrocknet und anschließend in der Nachbelichtungseinheit eines nyloflex® F III-Belichters mit UVA- und UVC-Licht nachbelichtet. Die Nachbelichtung dient einerseits dazu, noch reaktive Restmengen an Monomer und Fotoinitiator umzusetzen, andererseits wird die Plattenoberfläche hierdurch klebfreier.

### Belichtung von Flexodruckplatten mittels UV-Röhren

Die Belichtung von Flexodruckplatten mittels UV-Röhren wurde in der Hauptbelichtungseinheit eines nyloflex^{®} F III-Belichters vorgenommen, wobei die mit einem UVA-Meter der Fa. Kühnast ermittelte Leistung der UV/A-Strahlung auf Höhe der Plattenoberfläche im Mittel 15 mW/cm² betrug.

### Belichtung der Flexodruckplatten mittels UV-LED-Strahlung

Bei der verwendeten UV-LED-Einheit handelte es sich um ein Hochleistungsarray, das aus 8 quadratischen UV-LED-Modulen in einem kühlbaren Metallgehäuse zusammengesetzt war. Jedes UV-LED-Modul bestand hierbei aus 5 x 5 Einzeldiodenelementen, die zusammen in einem quadratischen Feld von ca. 8 x 8 mm angeordnet waren, so dass das Gesamtarray eine UV-Austrittsfläche von etwa 75 x 8 mm aufwies. Die verwendeten UV-LEDs besaßen ein Emissionsmaximum bei 365 nm und wurden mittels Wasserkühlung und einem zugehörigen Steuerungsgerät auf einem möglichst konstanten Leistungsniveau betrieben. Solche UV-LED-Einheiten sind z.B. von der Fa. Dr. Hönle AG (Gräfelfing, Deutschland) unter dem Namen "UV-LED Powerline" erhältlich.

### Beispiele A1-A5

In die Maskenschicht einer rückseitig vorbelichteten Flexodruckplatte vom Typ nyloflex^{®} ACE 114 D wurde zunächst wie oben erläutert mit Hilfe eines IR-Lasers ein Testmotiv eingeschrieben. Die Nichtbildbereiche bleiben hierbei aufgrund der noch verbleibenden Maskenschicht UV-undurchlässig, während durch die Entfernung der Maske in den Bildbereichen die Härtung der fotopolymerisierbaren Reliefschicht mittels aktinischer Strahlung ermöglicht wird.

Die so vorbereitete Flexodruckplatte wurde in einem ersten Belichtungsschritt zunächst mittels einer Transportvorrichtung gleichmäßig unter einer UV-LED-Einheit des beschriebenen Typs hindurchtransportiert und dadurch vorderseitig der Strahlung der UV-LED-Einheit ausgesetzt, wobei die Parameter Belichtungsgeschwindigkeit (Transportgeschwindigkeit der Platte unter der UV-LED-Einheit), Abstand der Plattenoberfläche zur Strahlquelle und die mittels UV-LED applizierte UV-Dosis der Tabelle 1 entnommen werden können.

Die UV-LED-belichtete Druckplatte wurde anschließend in einem zweiten Belichtungsschritt für die in Tabelle 1 angegebene Zeitdauer zusätzlich mit UV-Röhren in einem nyloflex^{®} F III-Belichter belichtet. Die Summe der UV-Dosis aus beiden Belichtungsschritten ist ebenfalls in Tabelle 1 aufgeführt.

Die belichtete Flexodruckplatte wurde schließlich wie vorher beschrieben laut den produktspezifischen empfohlenen Verarbeitungsparametern in einem lösemittelbasierten Entwicklungsschritt ausgewaschen, getrocknet und nachbelichtet.

### Beispiele A6

In die Maskenschicht einer rückseitig vorbelichteten Flexodruckplatte vom Typ nyloflex^{®} FAC 470 D (Dicke ohne Deckfolie 4,7 mm) wurde zunächst wie oben erläutert mit Hilfe eines IR-Lasers ein Testmotiv eingeschrieben. Die Nichtbildbereiche bleiben hierbei aufgrund der noch verbleibenden Maskenschicht UV-undurchlässig, während durch die Entfernung der Maske in den Bildbereichen die Härtung der fotopolymerisierbaren Reliefschicht mittels aktinischer Strahlung ermöglicht wird.

Die so vorbereitete Flexodruckplatte wurde in einem ersten Belichtungsschritt zunächst mittels einer Transportvorrichtung gleichmäßig unter einer UV-LED-Einheit des beschriebenen Typs hindurchtransportiert und dadurch vorderseitig der Strahlung der UV-LED-Einheit ausgesetzt, wobei die Parameter Belichtungsgeschwindigkeit (Transportgeschwindigkeit der Platte unter der UV-LED-Einheit), Abstand der Plattenoberfläche zur Strahlquelle und die mittels UV-LED applizierte UV-Dosis der Tabelle 1 entnommen werden können.

Die UV-LED-belichtete Druckplatte wurde anschließend in einem zweiten Belichtungsschritt für die in Tabelle 1 angegebene Zeitdauer zusätzlich mit UV-Röhren in einem nyloflex^{®} F III-Belichter belichtet. Die Summe der UV-Dosis aus beiden Belichtungsschritten ist ebenfalls in Tabelle 1 aufgeführt.

Die belichtete Flexodruckplatte wurde schließlich wie vorher beschrieben laut den produktspezifischen empfohlenen Verarbeitungsparametern in einem lösemittelbasierten Entwicklungsschritt ausgewaschen, getrocknet und nachbelichtet.

### Beispiel A7

Zunächst wurde ein Folienelement präpariert, das übereinander angeordnet folgende Schichten umfasst:
d) eine 125 µm dicke PET-Folie;
c2) eine ca. 3 µm dicke, digital bebilderbare Maskenschicht, enthaltend ein polymeres Bindemittel und Ruß (identisch mit der Maskenschicht, welche bei kommerziell erhältlichen Druckplatten der Marke nyloflex^{®} verwendet wird);
c1) eine raue UV-durchlässige Schicht enthaltend ein polymeres Bindemittel sowie poröse Silicapartikel.

Die raue UV-durchlässige Schicht wurde wie folgt erhalten:
Zunächst wurde eine Lösung von 7 Gewichtsteilen Macromelt 6900 in 90 Gewichtsteilen eines Lösemittelgemisches (45 Teile n-Propanol, 45 Teile Toluol, 10 Teile Benzylalkohol) unter Erwärmen auf 50 °C hergestellt. Zu dieser Lösung wurden anschließend 3 Gewichtsteile eines porösen Silicagels (Syloid^{®} ED-5 von Grace & Co., mittlerer Partikeldurchmesser 8,4 - 10,2 µm, Porenvolumen 1,8 ml/g) hinzugefügt. Das partikuläre Silicagel wurde in der Polymerlösung mittels eines Dispergiergeräts vom Typ ULTRA-TURRAX^{®} T 50 für eine Zeitdauer von 20 min bei 8000 U/min dispergiert. Die so erhaltene Dispersion wurde auf eine ca. 3 µm dicke digitale Maskenschicht aufgetragen, die sich auf einer 125 µm dicken PET-Folie befand. Die digitale Maskenschicht bestand aus ca. 65 % Macromelt 6900 sowie 35 % eines feinteiligen Rußes. Auf diese Art und Weise wurde ein Folienelement erzeugt, das die oben beschriebene Schichtfolge von PET-Folie,
Maskenschicht und rauer Substratschicht aufwies. Die Auftragsmenge der rauen Substratschicht betrug ca. 5 g/m².

Das beschriebene Folienelement wurde im Rahmen einer Standardproduktion der Druckplattentype nyloflex^{®} ACE 170 mittels Extrusion über die obere Kalanderwalze zugeführt, so dass ein Flexodruckelement erhalten wurde, welches übereinander angeordnet folgende Schichten umfasste:
a) eine 125 µm dicke, dimensionsstabile PET-Trägerfolie mit einer dünnen Haftschicht;
b) eine fotopolymerisierbare elastomere Schicht;
c1) eine raue UV-durchlässige Schicht enthaltend ein polymeres Bindemittel sowie poröse Silikapartikel mit einem Auftragsgewicht von ca. 5 g/m²;
c2) eine ca. 3 µm dicke, digital bebilderbare Maskenschicht, enthaltend ein polymeres Bindemittel und Ruß (identisch mit der Maskenschicht, welche bei kommerziell erhältlichen Druckplatten der Marke nyloflex^{®} verwendet wird);
d) eine 125 µm dicke PET-Schutzfolie.

In die Maskenschicht des so hergestellten Flexodruckelements wurde nach rückseitiger Vorbelichtung zunächst wie oben erläutert mit Hilfe eines IR-Lasers ein Testmotiv eingeschrieben. Die Nichtbildbereiche bleiben hierbei aufgrund der noch verbleibenden Maskenschicht UV-undurchlässig, während durch die Entfernung der Maske in den Bildbereichen die Härtung der fotopolymerisierbaren Reliefschicht mittels aktinischer Strahlung ermöglicht wird.

Die so vorbereitete Flexodruckplatte wurde in einem ersten Belichtungsschritt zunächst mittels einer Transportvorrichtung gleichmäßig unter einer UV-LED-Einheit des beschriebenen Typs hindurch transportiert und dadurch vorderseitig der Strahlung der UV-LED-Einheit ausgesetzt. Die Belichtungsgeschwindigkeit betrug 150 mm/min bei einem Abstand der Plattenoberfläche zur Strahlquelle von 5 mm. Die mittels UV-LED applizierte UV-Dosis betrug 1,8 J/cm².

Die UV-LED-belichtete Druckplatte wurde anschließend in einem zweiten Belichtungsschritt für 6 min zusätzlich mit UV-Röhren in einem nyloflex^{®} F III-Belichter belichtet. Die Summe der UV-Dosis aus beiden Belichtungsschritten betrug demnach 7,2 J/cm².

Die belichtete Flexodruckplatte wurde schließlich bei einer Auswaschgeschwindigkeit von 270 mm/min in einem lösemittelbasierten Entwicklungsschritt ausgewaschen, getrocknet und nachbelichtet.

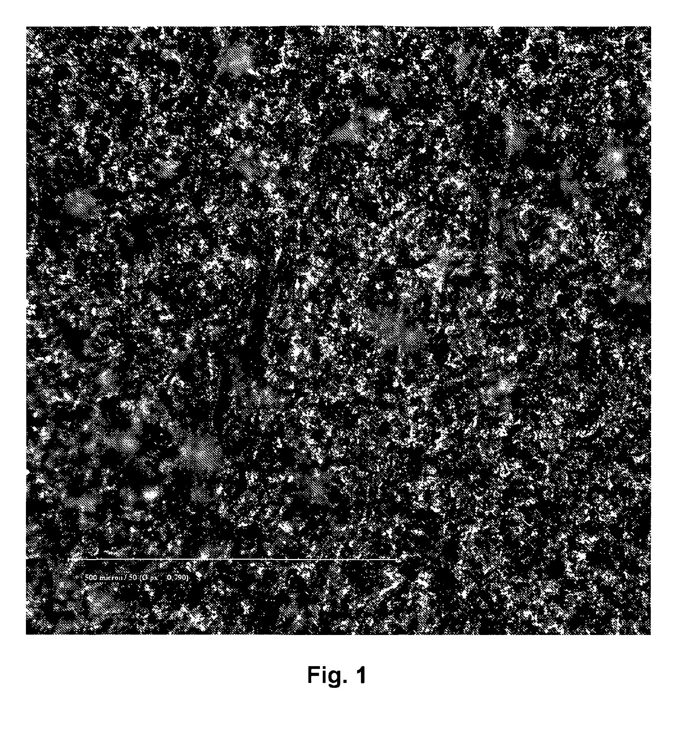

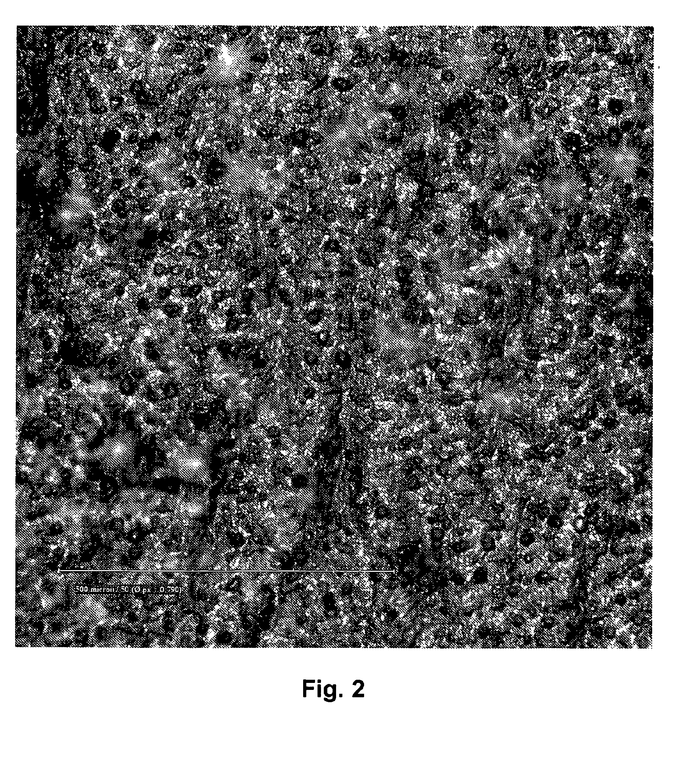

Vor und nach Durchführung des erfindungsgemäßen Verfahrens wurden fotografische Aufnahmen der Oberfläche des Flexodruckelements mit Hilfe eines Messmikroskops (Firma M-Service) angefertigt. Die Aufnahmen sind in den Figuren 1 und 2 wiedergegeben. Zum Vergleich wurde ein derartiges Flexodruckelement nach digitaler Bebilderung 15 Minuten lang mit konventionellen UV/A-Röhren (15 mW/cm²) in Umgebungsatmosphäre belichtet und ansonsten mit identischen Parametern entwickelt. Die Oberfläche dieses konventionell verarbeiteten Flexodruckelements ist in Bild 3 wiedergegeben.

### Somit zeigen

Figur 1 eine fotographische Aufnahme der Oberfläche des Flexodruckelements mit oberflächenrauer reliefbildender Schicht nach Ablation der digital bebilderbaren Schicht, aber vor Belichtung und Entwicklung;
Figur 2 eine fotographische Aufnahme der Oberfläche des Flexodruckelements mit oberflächenrauer reliefbildender Schicht nach Ablation der digital bebilderbaren Schicht, erfindungsgemäßer Belichtung und Entwicklung;

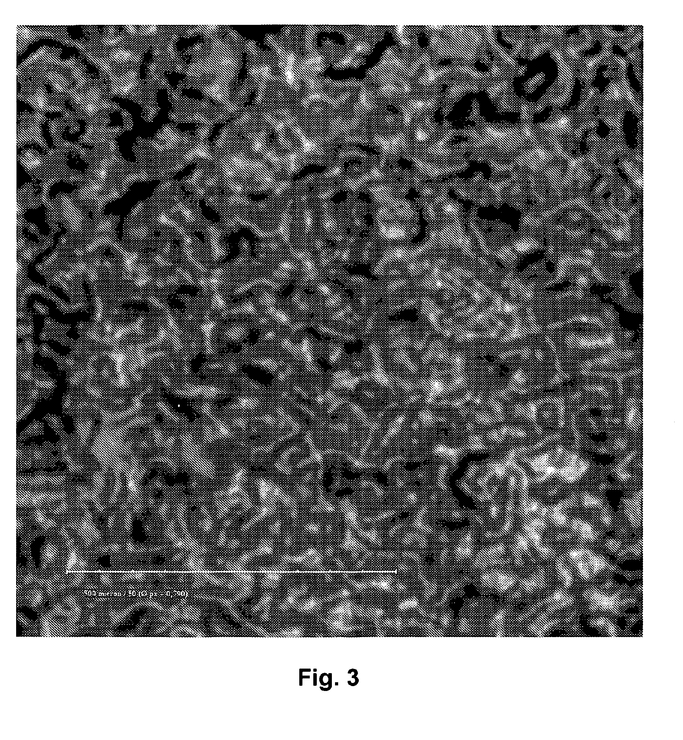

Figur 3 eine fotographische Aufnahme der Oberfläche des Flexodruckelements mit oberflächenrauer reliefbildender Schicht nach Ablation der digital bebilderbaren Schicht, konventioneller Belichtung ausschließlich mit einer UVA-Röhre und Entwicklung.

Anhand der Aufnahmen ist zu erkennen, dass sich die Rauheit der Substratoberfläche nach Durchführung des erfindungsgemäßen Verfahrens auf der druckenden Oberfläche reproduzieren lässt, während sich die Rauheit bei Belichtung mit Hilfe konventioneller UV/A-Röhren aufgrund der inhibierenden Wirkung des Sauerstoffs nicht auf die Oberfläche des druckenden Elements überträgt.

### Vergleichsbeispiel B1

In die Maskenschicht einer rückseitig vorbelichteten Flexodruckplatte vom Typ nyloflex^{®} ACE 114 D wurde zunächst wie oben erläutert mit Hilfe eines IR-Lasers ein Testmotiv eingeschrieben. Die Nichtbildbereiche bleiben hierbei aufgrund der noch verbleibenden Maskenschicht UV-undurchlässig, während durch die Entfernung der Maske in den Bildbereichen die Härtung der fotopolymerisierbaren Reliefschicht mittels aktinischer Strahlung ermöglicht wird.

Die so vorbereitete Flexodruckplatte wurde für die in Tabelle 1 angegebene Zeitdauer ausschließlich mit UV-Röhren in einem nyloflex^{®} F III-Belichter von der Vorderseite belichtet.

Die belichtete Flexodruckplatte wurde schließlich wie vorher beschrieben laut den produktspezifischen empfohlenen Verarbeitungsparametern in einem lösemittelbasierten Entwicklungsschritt ausgewaschen, getrocknet und nachbelichtet.

### Vergleichsbeispiel B2

In die Maskenschicht einer rückseitig vorbelichteten Flexodruckplatte vom Typ nyloflex^{®} ACE 114 D wurde zunächst wie oben erläutert mit Hilfe eines IR-Lasers ein Testmotiv eingeschrieben. Die Nichtbildbereiche bleiben hierbei aufgrund der noch verbleibenden Maskenschicht UV-undurchlässig, während durch die Entfernung der Maske in den Bildbereichen die Härtung der fotopolymerisierbaren Reliefschicht mittels aktinischer Strahlung ermöglicht wird.

Die so vorbereitete Flexodruckplatte wurde in einem einzigen Belichtungsschritt mittels einer Transportvorrichtung gleichmäßig unter zwei hintereinandergeschalteten UV-LED-Einheiten hindurchtransportiert und dadurch von der Vorderseite der Strahlung der beiden UV-LED-Einheiten ausgesetzt, wobei die Parameter Belichtungsgeschwindigkeit (Transportgeschwindigkeit der Platte unter den UV-LED-Einheiten), Abstand der Plattenoberfläche zur Strahlquelle und die mittels UV-LED applizierte UV-Dosis der Tabelle 1 entnommen werden können.

Die belichtete Flexodruckplatte wurde schließlich wie vorher beschrieben laut den produktspezifischen empfohlenen Verarbeitungsparametern in einem lösemittelbasierten Entwicklungsschritt ausgewaschen, getrocknet und nachbelichtet.

### Vergleichsbeispiel B3

In die Maskenschicht einer rückseitig vorbelichteten Flexodruckplatte vom Typ nyloflex^{®} ACE 114 D wurde zunächst wie oben erläutert mit Hilfe eines IR-Lasers ein Testmotiv eingeschrieben. Die Nichtbildbereiche bleiben hierbei aufgrund der noch verbleibenden Maskenschicht UV-undurchlässig, während durch die Entfernung der Maske in den Bildbereichen die Härtung der fotopolymerisierbaren Reliefschicht mittels aktinischer Strahlung ermöglicht wird.

Die so vorbereitete Flexodruckplatte wurde in einem ersten Schritt für die in Tabelle 1 angegebene Zeitdauer mit UV-Röhren in einem nyloflex^{®} F III-Belichter von der Vorderseite belichtet.

In einem weiteren Schritt wurde die Druckplatte anschließend mittels einer Transportvorrichtung gleichmäßig unter der oben beschriebenen UV-LED-Einheit hindurchtransportiert und dadurch von der Vorderseite der Strahlung der UV-LED-Einheit ausgesetzt, wobei die Parameter Belichtungsgeschwindigkeit (Transportgeschwindigkeit der Platte unter der UV-LED-Einheit), Abstand der Plattenoberfläche zur Strahlquelle und die mittels UV-LED applizierte UV-Dosis der Tabelle 1 entnommen werden können. Die Summe der UV-Dosis aus allen Belichtungsschritten ist ebenfalls in Tabelle 1 aufgeführt.

Die belichtete Flexodruckplatte wurde schließlich wie vorher beschrieben laut den produktspezifischen empfohlenen Verarbeitungsparametern in einem lösemittelbasierten Entwicklungsschritt ausgewaschen, getrocknet und nachbelichtet.

### Beurteilung der Testelemente

### a) Tiefe 400 µm-Negafivpunkt

Die Tiefe des 400 µm-Negativpunkts ist ein Maß für die Differenzierung zwischen Bild- und Nichtbildbereichen im Druck. Während es erwünscht ist, dass die druckenden Bildelemente stabil ausgebildet sind, sollte in den Nichtbildbereichen die Zwischentiefe möglichst hoch sein, damit die Nichtbildbereiche auch in einem längeren Druckprozess offen bleiben und nicht zu Fehlern im Druckbild führen.

### b) Minimale Dimension stabil ausgebildeter Positivelemente (Positivpunkt, Positivlinie, Raster)

Je kleiner die Dimension der ersten, stabil ausgebildeten Positivelemente ist, desto besser ist die Auflösung der Druckplatte und desto feinere Details können im Druckprozess reproduziert werden. Kleinere stabile Rastertonwerte erhöhen zudem den Tonwertumfang und damit den Kontrast insbesondere bei Tonwertverläufen und gerasterten Bildern.

### c) 60 µm-Gitternetz

Das 60 µm-Gitternetz ist ein Testelement, das gekreuzte feine Positivlinien im Motiv repräsentiert. Solche Elemente sind im Flexodruck kritisch, da sie durch die geringe Elementbreite schwierig stabil zu versockeln sind und gleichzeitig aufgrund Ihrer Geometrie anfällig gegenüber der Quellwirkung des Auswaschmittels sind.

Ist das Gitternetz nicht vollständig ausgebildet und / oder das Gitternetz ist zwar als solches ausgebildet, jedoch nach Rücktrocknung noch wellig verformt, so wird das Gitternetz mit "-" beurteilt.

Ist das Gitternetz nur noch minimal wellig (nur erkennbar bei Verwendung eines Mikroskops), aber ansonsten stabil ausgebildet, so wird das Gitternetz mit "o" beurteilt.

Ist das Gitternetz zwar stabil versockelt ausgebildet, die Linienbreite an der Oberfläche jedoch kleiner als in den Daten angelegt, so wird das Gitternetz mit "(+)" beurteilt.

Bei vollständiger, stabiler Ausbildung und einer Breite, die im wesentlichen der Breite des Elements in den Motivdaten entspricht, so wird das Gitternetz mit "+" beurteilt.

### d) Tonwert des 15%-Rasterfelds bei 146 Ipi, auf der Platte gemessen

Raster werden zur Reproduktion von Halbtönen eingesetzt, d.h. zur Darstellung von Motivbereichen, die nicht zu 100% einer der im Druckprozess eingesetzten Grundfarben entsprechen. Auf diese Art und Weise können Mischfarben unterschiedlicher Helligkeit erzeugt werden.

Im vorliegenden Fall wurde ein so genanntes "autotypisches Raster" verwendet, d.h. die gerasterte Fläche wird in eine feste Zahl von Rasterzellen aufgeteilt. Die Variation von Helligkeit und Farbeindruck erfolgt hauptsächlich über die Größe eines Punktes in dieser Zelle (die Amplitude).

Das verwendete Rasterfeld besitzt in den Motivdaten eine Flächendeckung von 15%. Der gemessene Tonwert dieses Felds an der Plattenoberfläche ist ein Maß für die Kopiergenauigkeit. Ist der auf der Platte gemessene Wert kleiner als in den Daten, so spricht man von Tonwertreduktion. Dies kann einerseits erwünscht sein, um beispielsweise den Tonwertzuwachs im eigentlichen Druckprozess zu kompensieren, andererseits sind Rasterpunkte unterhalb eines bestimmten Tonwerts dann nicht mehr stabil versockelt und werden nicht mehr ausgebildet. Dadurch gehen Grauabstufungen verloren und man hat einen geringeren Tonwertumfang im Druck. Bekannt ist der Effekt der Tonwertreduktion bei der Belichtung von digitalen Flexodruckplatten nach dem Stand der Technik mit UV-Röhren. Durch den polymerisationsinhibierenden Effekt des Sauerstoffs während der Belichtung wird die Polymerisation der Rasterpunkte gestört, so dass die Rasterpunkte auf der Platte kleiner werden als in den Daten angelegt. Allerdings ist die Stärke dieses Effekts von der Intensität der UV-Strahlung abhängig und kann daher schwankende Tonwerte bei Veränderungen in der Intensität der eingesetzten UV-Röhren nach sich ziehen.

Im Idealfall besitzen Rasterpunkte auf der Platte eine annähernd gleiche Flächendeckung wie in den zugrundeliegenden Daten, verfügen aber auch über ausreichende Vertiefungen zwischen den einzelnen Rasterpunkten, um im Druckprozess Farbablagerungen in der Nähe der druckenden Oberfläche zu verhindern.

### Interpretation der Testergebnisse

Wie man anhand der Beispiele A1-A5 und B2 erkennen kann, werden bei der Belichtung mit der intensiven UVA-Strahlung von UV-LEDs feine Positivelemente wie Punkte, Linien und Raster gut reproduziert. Insbesondere war hierbei auch überraschend, dass es trotz der hohen UV-Intensität zu keiner unerwünscht starken Erwärmung der Platte >50°C kam, so dass die Dimensionsstabilität eines PET-Folienträgers nicht beeinträchtigt wird, obwohl aufgrund der hohen UV-Intensität allein die auftretende Polymerisationswärme des Vernetzungsprozesses höhere Temperaturen erwarten lassen könnte.

An den auf der Platte gemessenen Rastertonwerte kann zudem abgelesen werden, dass der auf die Platte kopierte Tonwert bei Verwendung von UV-LED-Strahlung mit ca. 13 % dem zugrundeliegenden Datentonwert von 15% bei 146 Ipi sehr nahe kommt. Das heißt, die Belichtung erfolgt sehr kopiergenau. Gleichzeitig sind die bei Verwendung von UV-LED-Strahlung die Rasterpunkte an der Oberfläche kaum abgerundet, wodurch ein stabilerer und reproduzierbarer Druckprozess gewährleistet wird, da stark abgerundete feine Rasterpunkte abhängig von der Beistellung im Druckprozess stark unterschiedliche Tonwertzunahmen verursachen können. Die geringfügige, verbleibende Tonwertreduktion bei der Kopie auf die Platte ist jedoch durchaus erwünscht, da im Druckprozess immer eine leichte Tonwertzunahme durch die Druckbeistellung auftritt, so dass eine leichte Reduktion der Elemente hilft, diese im Druck zu kompensieren und so den Kontrastumfang des Druckbilds zu verbessern.

Allerdings wird für die Ausbildung bestimmter kritischer feiner Elemente wie einem Gitter aus 60 µm breiten Linien eine sehr hohe Dosis an UV-LED-Strahlung benötigt. Im Vergleichsbeispiel B2 genügen etwa 4,4 J/cm² reine UV-LED Leistung noch nicht, um ein solches Gitter hinreichend stabil auszubilden. Eine so hohe UV-LED-Dosis erfordert zudem viele LED-Elemente, um akzeptable Belichtungszeiten zu erhalten. Insbesondere bei automatisierten Durchlaufsystemen (z.B. in Kopplung mit einer nachgeschalteten Auswascheinheit) wären dann bei in den Beispielen verwendeten Platte ACE 114 D mit einer Auswaschgeschwindigkeit von 300 mm/min mehr als 5 hintereinandergeschaltete UV-LED-Leisten erforderlich, was enorme Kosten verursachen und damit den Belichtungsprozess unwirtschaftlich machen würde.

Anhand der Beispiele A2-A5 ist jedoch gut abzulesen, dass eine bestimmte Mindestdosis an UV-LED-Strahlung vorausgesetzt, auch eine kostengünstigere Kombination aus UV-LED-Strahlung und einer nachgeschalteten Ausbelichtung mit UV-Strahlung aus einer konventionellen Strahlquelle die gewünschte Kopiergenauigkeit ermöglicht. Speziell bei einer UV-LED-Dosis von > 1 J/cm² werden stabile, kopiergenaue Elemente auf der Platte erzeugt, indem die bei Belichtung mit UV-Strahlquellen niedrigerer Intensität auftretende Sauerstoffinhibierung unterdrückt wird. Ist die UV-LED-Dosis zu gering, kann es hingegen zu Ausbrüchen an feinen Elementen kommen, was im Druckprozess zu Schwankungen im Druckbild und fehlerhaften Drucken führt. Beispiel A1 verdeutlicht dies, da die auf der Platte gemessenen Tonwerte bei 15% Daten und 146 lpi noch schwanken, was auf Ausbrüche an den Rasterpunkten zurückzuführen ist. Hier ist die UV-LED-Initialdosis mit <1 J/cm² noch zu gering.

Beispiel A6 verdeutlicht, dass auch bei dickeren Flexodruckelementen, die beispielsweise zum Bedrucken von Wellpappe oder anderen rauen bzw. unebenen Substraten verwendet werden, durch eine Initialbelichtung mit UV-LEDs gefolgt von einer niederenergetischen Belichtung UV/A-Röhren sehr fein aufgelöste Daten kopiergenauer reproduziert werden können. Die Reproduktion eines 15 %-Tonwert bei einer Rasterweite von 146 Ipi liefert bei herkömmlicher Belichtung des gleichen Flexodruckelements mit UV/A-Röhren auf der Platte einen Tonwert von nur 2-3 %, während bei Durchführung des erfindungsgemäßen Verfahrens mit 10,6 % Tonwert auf der Platte ein deutlich dichter am Idealwert liegender Wert erhalten wird. Zudem besitzen die Rasterpunkte bei Durchführung des erfindungsgemäßen Verfahrens definierte, im Wesentlichen ebene Punktoberflächen.

Ein Umkehrung der Reihenfolge, also zuerst die Belichtung mit einer üblichen UV-Strahlquelle relativ niedriger Intensität (UVA-Röhren) und eine anschließende Belichtung mit hochenergetischer UV-LED-Strahlung erzeugt hingegen nicht den gewünschten Effekt (Vergleichsbeispiel B3), da eine bereits stattgefundene Inhibierung der Polymerisation durch Sauerstoff auch durch nachfolgende Belichtung mit hochenergetischer UV-Strahlung nicht mehr umkehrbar ist, d.h. die Reproduktion erfolgt dann nicht mehr kopiergenau.

| **Beispiel Nr.** | | **A1** | **A2** | **A3** | **A4** | **A5** | **A6** | **B1** | **B2** | **B3** |
|---|---|---|---|---|---|---|---|---|---|---|
| **Plattentyp** | | ACE 114 D | ACE 114 D | ACE 114 D | ACE 114 D | ACE 114 D | FAC 470 D | ACE 114 D | ACE 114 D | ACE 114 D |
| | | | | | | | | | | |

| Plattenverarbeitung | | | | | | | | | | |
|---|---|---|---|---|---|---|---|---|---|---|
| Rückseiten-Vorbelichtungszeit | sec | 19 | 19 | 19 | 19 | 19 | 115 | 19 | 19 | 19 |
| UV-Strahlquelle | | UV-LED 365 | UV-LED 365 | UV-LED 365 | UV-LED 365 | UV-LED 365 | UV-LED 365 | UV-Röhren | UV-LED 365 | UV-LED 365 |
| Anzahl UV-LED-Einheiten in Folge | mm | 1 | 1 | 1 | 1 | 1 | 1 | | 2 | 1 |
| Zeit erste / letzte Strahlquelle | sec | 3 | 6 | 6 | 6 | 6 | 11 | | 62 | 6 |
| Vorgeschaftete Belichtung UVA-Röhren | min | | | | | | | **15** | | 6 |
| UV.Intensität UV-LED | mW/cm² | 300,0 | 300,0 | 300,0 | 300,0 | 300,0 | 300,0 | --- | 300,0 | 300,0 |
| Abstand Strahlquelle / Platte | mm | **5** | **5** | **5** | **5** | **5** | **5** | **-** | **5** | **5** |
| Belichtungsgeschwindigkeit | mm/min | **300** | 150 | 150 | 150 | 150 | **80** | - | **120** | 150 |
| UV-Dosis LED | J/cm² | **0,9** | **1,8** | **1,8** | **1,8** | **1,8** | **3,3** | | **4,4** | **1,8** |
| Nachgeschaltete Belichtung UVA-Röhren | min | **6** | **2** | **4** | **6** | **8** | **6** | | | |
| UV-Dosis LED & Röhren | J/cm² | **6,3** | **3,6** | **5,4** | **7,2** | **9,0** | **8,7** | **13,5** | **4,4** | **7,2** |
| Auswaschgeschwindigkeit | mm/min | 270 | 270 | 270 | 270 | 270 | 80 | 270 | 270 | 270 |
| | | | | | | | | | | |

| **Belichtungseigenschaften** | | | | | | | | | | |
|---|---|---|---|---|---|---|---|---|---|---|
| Tiefe 400 µm Negativpunkt | µm | 180 | 190 | 185 | 185 | 170 | 135 | 170 | 150 | 180 |
| min. stabiler Positivpunkt | µm | 300 | 200 | 200 | 200 | 200 | 300 | 200 | 200 | 200 |
| min. stabile Positivlinie | µm | 80 | 120 | 80 | 40 | 40 | 100 | 20 | 80 | 60 |
| 60 µm Gitternetz | | 0 | 0 | 0 | + | + | 0 | (+) | - | (+) |
| min. stabiler Raster @123 Ipi | % | **5** | **5** | **4** | **3** | **4** | **7** | 5 | **3** | 5 |
| min. stabiler Raster @146 Ipi | % | **5** | **6** | **5** | **4** | **5** | **8** | 6 | **3** | 6 |
| Rastertonwert 15% Daten @146 Ipi | % | 8 - 10 | **13,2** | **13,0** | **12,7** | **12,9** | **10,6** | 6,6 | **13,4** | 6,2 |

## Patentansprüche

1. Verfahren zur Herstellung von Flexodruckformen, bei dem man als Ausgangsmaterial ein fotopolymerisierbares Flexodruckelement einsetzt, welches übereinander angeordnet mindestens umfasst
• einen dimensionsstabilen Träger, und
• mindestens eine fotopolymerisierbare reliefbildende Schicht, mindestens umfassend ein elastomeres Bindemittel, eine ethylenisch ungesättigte Verbindung und einen Fotoinitiator,
• optional eine raue UV-durchlässige Schicht, mindestens umfassend eine partikuläre Substanz,
• eine digital bebilderbare Schicht,
und das Verfahren mindestens die folgenden Schritte umfasst:
(a) Erzeugung einer Maske durch Bebilderung der digital bebilderbaren Schicht,
(b) Belichtung der fotopolymerisierbaren reliefbildenden Schicht durch die Maske hindurch mit aktinischem Licht und Fotopolymerisation der Bildbereiche der Schicht, und
(c) Entwicklung der fotopolymerisierten Schicht durch Auswaschen der nicht fotopolymerisierten Bereiche der reliefbildenden Schicht mit einem organischen Lösungsmittel oder durch thermische Entwicklung, **dadurch gekennzeichnet, dass**
der Schritt (b) zwei Belichtungsschritt (b-1) und (b-2) umfasst, wobei in einem ersten Schritt (b-1) eine Belichtung mit aktinischem Licht mit einer Intensität von ≥ 100 mW/cm² aus einer Mehrzahl von UV-LEDs erfolgt und anschließend in einem zweiten Schritt (b-2) eine Belichtung mit aktinischem Licht mit einer Intensität von < 100 mW/cm² aus einer von UV-LEDs verschiedenen UV-Strahlungsquelle erfolgt.

2. Verfahren nach Anspruch 1, **dadurch gekennzeichnet, dass** die in Schritt (b-2) eingesetzte Strahlungsquelle eine UV-Röhre oder ein UV-Strahler ist.

3. Verfahren nach Anspruch 1 oder 2, **dadurch gekennzeichnet, dass** die in Schritt (b-1) eingesetzten UV-LEDs ein Emissionsmaximum im Wellenlängenbereich von 350-405 nm, beispielsweise bei 350 nm, 365 nm, 375 nm, 385 nm, 395 nm oder 405 nm aufweisen.

4. Verfahren nach einem der Ansprüche 1 bis 3, **dadurch gekennzeichnet, dass** die Intensität im ersten Belichtungsschritt (b-1) ≥ 150 mW/cm² beträgt.

5. Verfahren nach einem der Ansprüche 1 bis 4, **dadurch gekennzeichnet, dass** die Intensität im zweiten Belichtungsschritt (b-2) ≤ 50 mW/cm² beträgt.

6. Verfahren nach einem der Ansprüche 1 bis 5, **dadurch gekennzeichnet, dass** die Strahlungsdosis im ersten Belichtungsschritt (b-1) 1 bis 4 J/cm² und im zweiten Belichtungsschritt (b-2) 2 bis 8 J/cm² beträgt.

7. Verfahren nach einem der Ansprüche 1 bis 6, **dadurch gekennzeichnet, dass** die digital bebilderbare Schicht eine laserablatierbare Schicht ist.

8. Verfahren nach einem der Ansprüche 1 bis 7, **dadurch gekennzeichnet, dass** zwischen fotopolymerisierbarer reliefbildender Schicht und digital bebilderbarer Schicht eine raue UV-durchlässige Schicht, mindestens umfassend eine partikuläre Substanz mit einem mittleren Teilchendurchmesser von 0,5 - 50 µm, vorgesehen ist.

9. Verfahren nach einem der Ansprüche 1 bis 8, **dadurch gekennzeichnet, dass** die raue UV-durchlässige Schicht ein polymeres Bindemittel oder ein Wachs enthält.

10. Vorrichtung zur in-line-Produktion von Flexodruckplatten mittels digitaler Bebilderung, welche mindestens umfasst:
(A) optional eine Einheit zur digitalen Bebilderung des Flexodruckelements,
(B) eine erste Belichtungseinheit, umfassend eine Mehrzahl von in einem Array angeordneten LEDs, welche UV-Licht mit einer Intensität von ≥ 100 mW/cm² zu emittieren imstande sind,
(C) eine zweite Belichtungseinheit, umfassend mindestens eine von LEDs verschiedene UV-Strahlungsquelle, bevorzugt eine UV-Röhre oder einen UV-Strahler,
(D) eine Auswascheinheit,
(E) eine Trocknungseinheit,
(F) optional eine Nachbehandlungseinheit,
(G) optional eine Ausgabeeinheit für die erhaltenen Flexodruckplatten, sowie
(H) Transporteinheiten für die Flexodruckelemente bzw. -formen, die die Einheiten (A) bis (G) miteinander verbinden.

## Claims

1. Method for producing flexographic printing plates, using as starting material a photopolymerizable flexographic printing element which at least comprises, arranged one atop another,
• a dimensionally stable support, and
• at least one photopolymerizable, relief-forming layer, at least comprising an elastomeric binder, an ethylenically unsaturated compound, and a photoinitiator,
• optionally a rough, UV-transparent layer, at least comprising a particulate substance,
• a digitally imagable layer,
and the method comprises at least the following steps:
(a) producing a mask by imaging the digitally imagable layer,
(b) exposing the photopolymerizable, relief-forming layer through the mask with actinic light, and photopolymerizing the image regions of the layer, and
(c) developing the photopolymerized layer by washing out the unphotopolymerized regions of the relief-forming layer with an organic solvent, or by thermal development, **characterized in that**
step (b) comprises two exposure steps (b-1) and (b-2), where in a first step (b-1) exposure with actinic light takes place with an intensity of ≥ 100 mW/cm² from a plurality of UV-LEDs and subsequently, in a second step (b-2), exposure takes place with actinic light with an intensity of < 100 mW/cm² from a UV radiation source other than UV-LEDs.

2. Method according to Claim 1, **characterized in that** the radiation source used in step (b-2) is a UV tube or a UV lamp.

3. Method according to Claim 1 or 2, **characterized in that** the UV-LEDs used in step (b-1) have an emission maximum in the wavelength range of 350-405 nm, for example at 350 nm, 365 nm, 375 nm, 385 nm, 395 nm or 405 nm.

4. Method according to any of Claims 1 to 3, **characterized in that** the intensity in the first exposure step (b-1) is ≥ 150 mW/cm².

5. Method according to any of Claims 1 to 4, **characterized in that** the intensity in the second exposure step (b-2) is ≤ 50 mW/cm².

6. Method according to any of Claims 1 to 5, **characterized in that** the radiation dose in the first exposure step (b-1) is 1 to 4 J/cm² and in the second exposure step (b-2) is 2 to 8 J/cm².

7. Method according to any of Claims 1 to 6, **characterized in that** the digitally imagable layer is a laser-ablatable layer.

8. Method according to any of Claims 1 to 7, **characterized in that** between photopolymerizable, relief-forming layer and digitally imagable layer there is a rough, UV-transparent layer, at least comprising a particulate substance having an average particle diameter of 0.5 - 50 µm.

9. Method according to any of Claims 1 to 8, **characterized in that** the rough, UV-transparent layer comprises a polymeric binder or a wax.

10. Apparatus for inline production of flexographic printing plates by means of digital imaging, at least comprising:
(A) optionally a unit for digitally imaging the flexographic printing element,
(B) a first exposure unit, comprising a plurality of LEDs arranged in an array and capable of emitting UV light with an intensity of ≥ 100 mW/cm²,
(C) a second exposure unit, comprising at least one UV radiation source other than LEDs, preferably a UV tube or a UV lamp,
(D) a washing unit,
(E) a drying unit,
(F) optionally an aftertreating unit,
(G) optionally a delivery unit for the resulting flexographic printing plates, and
(H) transport units for the flexographic printing elements and plates, connecting the units (A) to (G) with one another.

## Revendications

1. Procédé pour la fabrication de plaques d'impression flexographiques, dans lequel on utilise comme matière première un élément d'impression flexographique photopolymérisable, qui comprend, disposés l'un au-dessus de l'autre, au moins
• un support de dimensions stables, et
• au moins une couche en relief photopolymérisable, comprenant au moins un liant élastomère, un composé éthyléniquement non saturé, et un photo-initiateur,
• en option une couche rugueuse perméable aux UV, comprenant au moins une substance particulaire,
• une couche illustrable numériquement,
et le procédé comprend au moins les étapes suivantes:
(a) production d'un masque par illustration de la couche illustrable numériquement,
(b) éclairage de la couche en relief photopolymériable à travers le masque avec une lumière actinique et photopolymérisation des zones d'image de la couche, et
(c) développement de la couche photopolymérisée par lavage des zones non photopolymérisées de la couche en relief avec un solvant organique ou par développement thermique,
**caractérisé en ce que** l'étape (b) comprend deux étapes d'éclairage (b-1) et (b-2), dans lequel on effectue dans une première étape (b-1) un éclairage avec une lumière actinique avec une intensité de ≥ 100 mW/cm² à partir d'une multiplicité de LED UV et on effectue ensuite dans une deuxième étape (b-2) un éclairage avec une lumière actinique de < 100 mW/cm² à partir d'une source de rayonnement UV différente de LED UV.

2. Procédé selon la revendication 1, **caractérisé en ce que** la source de rayonnement utilisée dans l'étape (b-2) est un tube UV ou un émetteur de rayonnement UV.

3. Procédé selon la revendication 1 ou 2, **caractérisé en ce que** les LED UV utilisés dans l'étape (b-1) présentent un maximum d'émission dans la plage de longueur d'onde de 350-405 nm, par exemple à 350 nm, 365 nm, 375 nm, 385 nm, 395 nm ou 405 nm.

4. Procédé selon l'une quelconque des revendications 1 à 3, **caractérisé en ce que** l'intensité dans la première étape d'éclairage (b-1) vaut ≥ 150 mW/cm².

5. Procédé selon l'une quelconque des revendications 1 à 4, **caractérisé en ce que** l'intensité dans la deuxième étape d'éclairage (b-2) vaut ≤ 50 mW/cm².

6. Procédé selon l'une quelconque des revendications 1 à 5, **caractérisé en ce que** la dose de rayonnement dans la première étape d'éclairage (b-1) vaut 1 à 4 J/cm², et dans la deuxième étape d'éclairage (b-2) 2 à 8 J/cm².

7. Procédé selon l'une quelconque des revendications 1 à 6, **caractérisé en ce que** la couche illustrable numériquement est une couche pouvant subir une ablation par laser.

8. Procédé selon l'une quelconque des revendications 1 à 7, **caractérisé en ce qu'**il est prévu entre la couche en relief photopolymérisable et la couche illustrable numériquement une couche rugueuse perméable aux UV, comprenant au moins une substance particulaire avec un diamètre moyen de particule de 0,5 - 50 µm.

9. Procédé selon l'une quelconque des revendications 1 à 8, **caractérisé en ce que** la couche rugueuse perméable aux UV contient un liant polymère ou une cire.

10. Dispositif pour la fabrication en ligne de plaques d'impression flexographiques au moyen d'une illustration numérique, qui comprend au moins:
(A) en option, une unité pour l'illustration numérique de l'élément d'impression flexographique,
(B) une première unité d'éclairage, comprenant une multiplicité de LED disposées en un réseau, qui sont en mesure d'émettre une lumière UV avec une intensité de ≥ 100 mW/cm²,
(C) une deuxième unité d'éclairage, comprenant au moins une source de rayonnement UV différente de LED, de préférence un tube UV ou un émetteur de rayonnement UV,
(D) une unité de lavage,
(E) une unité de séchage,
(F) en option une unité de post-traitement,
(G) en option une unité de sortie pour les plaques d'impression flexographiques obtenues, ainsi que
(H) des unités de transport pour les éléments ou les plaques d'impression flexographiques, qui relient l'une à l'autre les unités (A) à (G).
